# EUROPEAN PATENT APPLICATION

(11) **EP 4 397 731 A1**
(43) Date of publication of application: **10.07.2024**
(21) Application number: 22864471.2
(22) Date of filing: 29.08.2022
(51) Int. Cl.: C09J 11/06, C09J 163/00, C09J 179/08, H01L 21/60

(54) **ADHESIVE, SUBSTRATE HAVING ADHESIVE, CIRCUIT BOARD HAVING ADHESIVE LAYER, LAYERED PRODUCT, METHOD FOR PRODUCING LAYERED PRODUCT, AND METHOD FOR PRODUCING SEMICONDUCTOR DEVICE**

(30) Priority: 01.09.2021 JP 2021142145
(71) Applicant: Toray Industries, Inc., Tokyo 103-8666 (JP)
(72) Inventor: ARIMOTO, Yukari, Otsu-shi, Shiga 520-8558 (JP); FUJIWARA, Takenori, Otsu-shi, Shiga 520-8558 (JP); ARAKI, Hitoshi, Otsu-shi, Shiga 520-8558 (JP)
(74) Representative: Kador & Partner Part mbB
(86) International application number: PCT/JP2022/032346
(87) International publication number: WO 2023/032888

(57) **Abstract**

The present invention aims to provide a pressure sensitive adhesive having high pressure sensitive adhesiveness and heat resistance and serves to makes it possible to transfer and mount a large number of semiconductor elements at once even when the process involves a step for applying heat to the semiconductor elements. It provides a pressure sensitive adhesive including a polyimide copolymer (A) having at least an acid dianhydride residue and a diamine residue and also comprising a dimer acid epoxy resin (B), wherein the diamine residue has a diamine residue (A1) as represented by the formula (1) in which n is a natural number of 1 or more and 15 or less (hereinafter referred to as the diamine residue (A1)), a diamine residue (A2) as represented by the formula (1) in which n is a natural number of 16 or more and 50 or less (hereinafter referred to as the diamine residue (A2)), and a diamine residue (A3) having a phenolic hydroxyl group (hereinafter referred to as the diamine residue (A3)) and also wherein the diamine residue (A1) accounts for 50.0 mol% or more and 95.0 mol% or less, the diamine residue (A2) accounting for 1.0 mol% or more and 40.0 mol% or less, and the diamine residue (A3) accounting for 1.0 mol% or more and 30.0 mol% or less, of all diamine residues, which account for 100.0 mol%, in the polyimide copolymer (A).

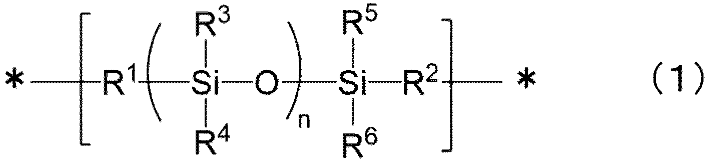

## Description

### TECHNICAL FIELD

The present invention relates to a pressure sensitive adhesive, a substrate coated with a pressure sensitive adhesive layer, a layered body, and a method for producing a semiconductor device using them. More specifically, it relates to a pressure sensitive adhesive composition that is suitable for temporary bonding and mounting of semiconductor elements and also relates to a substrate coated with a pressure sensitive adhesive layer, a layered body, and a method for producing a semiconductor device that use it.

### BACKGROUND ART

In general, semiconductor elements to be incorporated in a semiconductor device are transferred and mounted on a circuit board or the like by the pick-and-place method using a tool such as flip chip bonder. In recent years, advanced and compact semiconductor devices have come in wider use, and accordingly, semiconductor elements incorporated in them have also been miniaturized and slimmed down, and the numbers of these elements being mounted on them have been increasing.

Furthermore, devices using semiconductor chips such as gallium-arsenide or indium-phosphide chips are now facing problems arising from heat generation that occurs while the device is driven, and in order to enhance heat dissipation, there have been efforts intended to bond chips directly to a substrate with different heat dissipation properties, such as silicon substrate, to promote heat dissipation from the device so that the device can be driven efficiently (Patent documents 1 and 2).

Under such circumstances, the technique of transferring and mounting chips using the stamping method have also been adopted as a means of processing multiple semiconductor elements at once. According to this method, it is possible to transfer and mount a large number of semiconductor elements at once by using a stamp head provided with a pattern sheet made of a pressure sensitive adhesive material such as silicone based rubber or polydimethyl siloxane resin (Patent documents 3 and 4).

On the other hand, such pressure sensitive adhesive materials have been used as pressure sensitive adhesives not only for transferring and mounting semiconductor elements but also for bonding substrates together or the like. For instance, in the field of power semiconductors, in order to prevent warping and cracking of substrates from being occurring during the production of a thin-film type device substrate, a support substrate is attached to it before processing. For this operation, there is a disclosed document that proposes the use of a polyimide copolymer containing siloxanes with varying chain lengths in its structure as a pressure sensitive adhesive to adhere a support substrate, which is intended to serve for suppression of void formation during high-temperature processing steps such as ion implantation, which is essential in the production of a power semiconductor, and also serve for easy removal of it with a solvent after the processing (Patent document 5). Furthermore, it has also been disclosed that if a crosslinking agent is added to the polyimide copolymer containing siloxanes in its structure, it works to improve its chemical resistance, making it suitable for use as a copper-clad substrate for the tape automated bonding (TAB) technique (Patent document 6).

### PRIOR ART DOCUMENTS

### PATENT DOCUMENTS

Patent document 1: Japanese Unexamined Patent Publication (Kokai) No. 2019-54120
Patent document 2: Japanese Unexamined Patent Publication (Kokai) No. 2006-108556
Patent document 3: Japanese Unexamined Patent Publication (Kokai) No. 2015-140372
Patent document 4: Japanese Unexamined Patent Publication (Kokai) No. 2020-129638
Patent document 5: International Publication WO 2016/021646
Patent document 6: Japanese Unexamined Patent Publication (Kokai) No. HEI 10-226778

### SUMMARY OF INVENTION

### PROBLEMS TO BE SOLVED BY THE INVENTION

For the techniques disclosed in Patent documents 1 and 2, a high temperature and a high pressure have to be applied in order to bond semiconductor elements and a heat-dissipating substrate directly to each other. Therefore, the semiconductor elements have to be transferred and mounted one by one by using a flip chip bonder, which can perform bonding at high temperatures, but this leads to the problem of the necessity of a long period of time for the transfer and mounting steps.

In comparison with this, in the case of the techniques disclosed in Patent documents 3 and 4, although they can serve for the transfer and mounting of a large number of semiconductor elements at once, they are not applicable to processes that require high-temperature mounting, such as direct bonding, because the resin used for the stamping head is generally not sufficiently high in heat resistance.

Furthermore, in the case of the polyimide copolymers proposed in Patent documents 5 and 6, although they are high in heat resistance, they are specially designed for achieving a high processability after being bonded to substrates or copper-clad foils, and therefore, they are so high in adhesiveness that, when attempting to apply them to the transfer of small devices such as semiconductor elements, problems are inevitable such as the difficulty in their transfer itself and the presence of significant residual material coming from the adhesive and left on the chip surface.

In view of this, the present inventors have developed a technique that can solve the problems with the conventional technologies described above and serve to transfer and mount a large number of semiconductor elements at once even under conditions that require the application of high temperatures for processing steps such as direct bonding.

### MEANS OF SOLVING THE PROBLEMS

To solve the problems described above, the pressure sensitive adhesive according to the present invention has compositional features as follows. Specifically, it is:
[1] A pressure sensitive adhesive comprising a polyimide copolymer (A) having at least an acid dianhydride residue and a diamine residue and also comprising a dimer acid epoxy resin (B),
   wherein the diamine residue has a diamine residue (A1) as represented by the formula (1) in which n is a natural number of 1 or more and 15 or less (hereinafter referred to as the diamine residue (A1)), a diamine residue (A2) as represented by the formula (1) in which n is a natural number of 16 or more and 50 or less (hereinafter referred to as the diamine residue (A2)), and a diamine residue (A3) having a phenolic hydroxyl group (hereinafter referred to as the diamine residue (A3)), and
   wherein the diamine residue (A1) accounts for 50.0 mol% or more and 95.0 mol% or less, the diamine residue (A2) accounting for 1.0 mol% or more and 40.0 mol% or less, and the diamine residue (A3) accounting for 1.0 mol% or more and 30.0 mol% or less, of all diamine residues, which account for 100.0 mol%, in the polyimide copolymer (A). 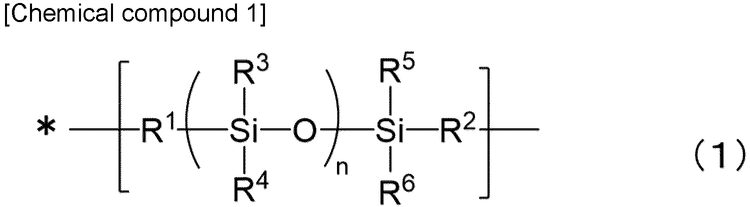 (In the formula (1), R¹ and R² may be identical to or different from each other and they each represent an alkylene group containing 1 to 30 carbon atoms or a phenylene group. R³ to R⁶ may be identical to or different from each other and they each represent an alkyl group containing 1 to 30 carbon atoms, a phenyl group, or a phenoxy group. In addition, * denotes a bonding site.)
[2] A pressure sensitive adhesive as set forth in [1] given above including 5 parts by weight or more and 50 parts by weight or less of a dimer acid epoxy resin (B) relative to 100 parts by weight of the polyimide copolymer (A).
[3] A pressure sensitive adhesive as set forth in either [1] or [2] given above further including a crosslinking agent (C) having either an alkoxy methyl group or a methylol group.
[4] A pressure sensitive adhesive as set forth in any one of [1] to [3] given above wherein the total amount of the diamine residue (A1) and the diamine residue (A2) accounts for 70.0 mol% or more and 98.0 mol% or less of all diamine residues, which account for 100.0 mol%, in the polyimide copolymer (A) and also wherein the molar ratio between the diamine residue (A1) and the diamine residue (A2) is in the range of 5:1 to 30:1.
[5] A pressure sensitive adhesive as set forth in either [3] or [4] given above including 0.1 part by weight or more and 1.5 parts by weight or less of the crosslinking agent (C) relative to 100 parts by weight of the polyimide copolymer (A).
[6] A substrate coated with a pressure sensitive adhesive layer including a support substrate having thereon a pressure sensitive adhesive layer made of a pressure sensitive adhesive as set forth in any one of [1] to [5] given above.
[7] A substrate coated with a pressure sensitive adhesive layer as set forth in [6] given above wherein the pressure sensitive adhesive layer present on the support substrate has a thickness of 0.1 µm or more and 10 µm or less.
[8] A layered body including semiconductor elements held on the pressure sensitive adhesive layer surface of the substrate coated with a pressure sensitive adhesive layer as set forth in either [6] or [7] given above.
[9] A layered body as set forth in [8] given above having a patterned pressure sensitive adhesive layer.
[10] A production method for a layered body, including:
   a step for placing a laser-transmissive substrate laid with semiconductor elements at least containing a laser-transmissive substrate and semiconductor elements stacked in this order and a substrate coated with a pressure sensitive adhesive layer as set forth in either [6] or [7] given above in such a manner that the surface of the former where the semiconductor elements are exposed and the surface of the latter where the pressure sensitive adhesive layer is exposed face each other, and
   a subsequent step for applying laser light to the laser-transmissive substrate by irradiating that surface of the laser-transmissive substrate laid with semiconductor elements which is opposite to the surface where the semiconductor elements are exposed so that the semiconductor elements are transferred to the substrate coated with a pressure sensitive adhesive layer.
[11] A production method for a layered body as set forth in [10] given above further, including a step for removing part of the pressure sensitive adhesive layer.
[12] A production method for a semiconductor device using a layered body as set forth in either [8] or [9] given above, including:
   a step for placing the layered body and the circuit board in such a manner that the surface of the former where the semiconductor elements are exposed faces the latter and establishing an electric connection between the semiconductor elements and the circuit board by thermocompression bonding, and
   a subsequent step for removing the substrate part coated with a pressure sensitive adhesive layer present in the layered body from the semiconductor elements.
[13] A circuit board coated with a pressure sensitive adhesive layer including a circuit board having thereon a pressure sensitive adhesive layer as set forth in any one of [1] to [5] given above.
[14] A layered body including a circuit board laid with a pressure sensitive adhesive layer as set forth in [13] given above and semiconductor elements held on the surface thereof where the pressure sensitive adhesive layer is exposed.
[15] A production method for a semiconductor device using a layered body as set forth in [14] given above, including:
   a step for applying a pressure in the stacking direction to the layered body to break the pressure sensitive adhesive layer in order to bring the circuit board into contact with the semiconductor elements so that an electric connection is established between the circuit board and the semiconductor elements.
[16] A production method for a semiconductor device, including:
   a step for placing a layered body having a substrate, a pressure sensitive adhesive layer, and a plurality of semiconductor elements stacked in this order and a circuit board in such a manner that the surface of the former where the semiconductor elements are exposed faces the latter,
   a step for heating and press-bonding the semiconductor elements and the circuit board at a temperature of 80°C or more and less than 300°C to establish an electric connection between them, and
   a subsequent step for removing the pressure sensitive adhesive layer and the substrate part present in the layered body from the semiconductor elements.
[17] A production method for a semiconductor device, including a step for applying a pressure in the stacking direction to a layered body having a circuit board, a pressure sensitive adhesive layer, and a plurality of semiconductor elements stacked in this order to break the pressure sensitive adhesive layer in order to bring the circuit board into contact with the semiconductor elements so that an electric connection is established between the circuit board and the semiconductor elements.
[18] A production method for a semiconductor device as set forth in either [16] or [17] given above, wherein the pressure sensitive adhesive layer contains polyimide.

### ADVANTAGEOUS EFFECTS OF THE INVENTION

The pressure sensitive adhesive according to the present invention is very high in adhesiveness and heat resistance, and accordingly, the present invention makes it possible to perform simultaneous transfer and mounting of a large number of semiconductor elements even when using a process involving a step for applying heat to the semiconductor elements.

### DESCRIPTION OF PREFERRED EMBODIMENTS

The pressure sensitive adhesive according to the present invention is:
a pressure sensitive adhesive including a polyimide copolymer (A) having at least an acid dianhydride residue and a diamine residue and also including a dimer acid epoxy resin (B),
wherein the diamine residue has a diamine residue (A1) as represented by the formula (1) in which n is a natural number of 1 or more and 15 or less, a diamine residue (A2) as represented by the formula (1) in which n is a natural number of 16 or more and 50 or less,
and a diamine residue (A3) that has a phenolic hydroxyl group, and
wherein the diamine residue (A1) accounts for 50.0 mol% or more and 95.0 mol% or less, the diamine residue (A2) accounting for 1.0 mol% or more and 40.0 mol% or less, and the diamine residue (A3) accounting for 1.0 mol% or more and 30.0 mol% or less, of all diamine residues, which account for 100.0 mol%, in the polyimide copolymer (A).

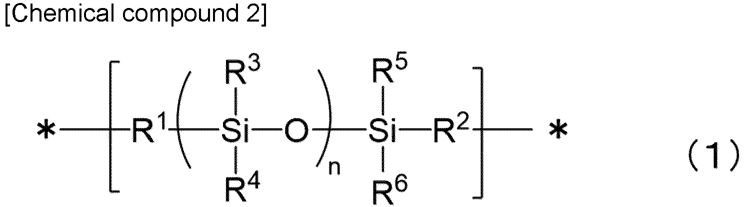

In the formula (1), R¹ and R² may be identical to or different from each other and they each represent an alkylene group containing 1 to 30 carbon atoms or a phenylene group. R³ to R⁶ may be identical to or different from each other and they each represent an alkyl group containing 1 to 30 carbon atoms, a phenyl group, or a phenoxy group. In addition, * denotes a bonding site.

Each of the components is described below.

The pressure sensitive adhesive according to the present invention is capable of maintaining pressure sensitive adhesiveness even after undergoing curing treatments, such as reaction with a crosslinking agent or a curing agent and heat treatment, and is characterized by allowing the items held by the pressure sensitive adhesive to be held and detached reversibly.

The polyimide copolymer (A) used for the present invention has an acid dianhydride residue and a diamine residue and can be prepared by performing copolymerization of at least a diamine having a diamine residue (A1), a diamine having a diamine residue (A2), and a diamine having a diamine residue (A3) as diamine components in the process of polymerizing the polyimide copolymer. If the polyimide copolymer (A) has a diamine residue (A1) as represented by the formula (1) in which n is a natural number of 1 or more and 15 or less and a diamine residue (A2) as represented by the formula (1) in which n is a natural number of 16 or more and 50 or less and if, at the same time, the diamine residue (A1) accounts for 50.0 mol% or more and 95.0 mol% or less while the diamine residue (A2) accounts for 1.0 mol% or more and 40.0 mol% or less of all diamine residues, which account for 100.0 mol%, in the polyimide copolymer (A), it allows those portions having the structure of the diamine residue (A2) to be aggregated in the outermost surface of the pressure sensitive adhesive layer in the step for forming the pressure sensitive adhesive layer on the substrate so that the adhesiveness of the outermost surface can be adjusted properly to allow the items thereon to be held and detached reversibly. If the polyimide copolymer (A) further contains a diamine residue (A3), it allows the dimer acid modified epoxy resin (B) that will be described later to work for forming a crosslinked structure.

For the diamine that has a diamine residue (A2), the number n in the formula (1) is more preferably a natural number in the range of 16 or more and 25 or less. If it is in this range, it serves to ensure an improved heat resistance.

In the polyimide copolymer (A) that is present in the pressure sensitive adhesive according to the present invention, the diamine residue (A1) accounts for 50.0 mol% or more and 95.0 mol% or less of all diamine residues, which account for 100.0 mol%. If the diamine residue (A1) contained therein accounts for a proportion in this rage, it serves to ensure a high adhesiveness to form a layered body with semiconductor elements being held on the pressure sensitive adhesive layer with a high yield. It is more preferable for the diamine residue (A1) to account for 70.0 mol% or more and 90.0 mol% or less of all diamine residues, which account for 100.0 mol%, in the polyimide copolymer (A). If in the polyimide copolymer (A), the diamine residue (A1) accounts for 70.0 mol% or more of all diamine residues, which account for 100.0 mol%, in the polyimide copolymer (A), it allows the semiconductor elements to be held without applying an excessively large pressure and serves to prevent damage from occurring to the semiconductor elements. Furthermore, if in the polyimide copolymer (A), the diamine residue (A1) accounts for 90.0 mol% or less of all diamine residues, which account for 100.0 mol%, in the polyimide copolymer (A), it serves to form a layered body laid with semiconductor elements in which the semiconductor elements are prevented from being buried in the pressure sensitive adhesive.

In addition, in the polyimide copolymer (A) that is present in the pressure sensitive adhesive according to the present invention, the diamine residue (A2) accounts for 1.0 mol% or more and 40.0 mol% or less of all diamine residues, which account for 100.0 mol%, in the polyimide copolymer (A). This serves to allow those portions having the structure of the diamine residue (A2) to be aggregated in the outermost surface of the pressure sensitive adhesive layer so that the adhesiveness of the outermost surface of the pressure sensitive adhesive layer can be adjusted properly to allow the items thereon to be held and detached reversibly. It is more preferable for the diamine residue (A2) to account for 2.0 mol% or more and 30.0 mol% or less of all diamine residues, which account for 100.0 mol%, in the polyimide copolymer (A). If the diamine residue (A2) accounts for 2.0 mol% or more of all diamine residues, which account for 100.0 mol%, in the polyimide copolymer (A), it serves to allow those portions having the structure of the diamine residue (A2) to be distributed uniformly in the outermost surface to ensure a reduced unevenness in pressure sensitive adhesiveness. On the other hand, if the diamine residue (A2) accounts for 30.0 mol% or less, it serves to prevent the pressure sensitive adhesive layer from being decomposed easily during heat treatment performed in the steps for the transfer and mounting of the semiconductor elements, thereby ensuring a high heat resistance.

It is preferable that in the polyimide copolymer (A), the total amount of the diamine residue (A1) and the diamine residue (A2) accounts for 70.0 mol% or more and 98.0 mol% or less of all diamine residues, which account for 100.0 mol%, and that the molar ratio between the diamine residue (A1) and the diamine residue (A2) is in the range of 5:1 to 30:1.

If the total amount of the diamine residue (A1) and the diamine residue (A2) accounts for 70.0 mol% or more and 98.0 mol% or less of all diamine residues, which account for 100.0 mol%, in the polyimide copolymer (A), the glass transition temperature of the polyimide copolymer (A) can be lowered nearly to room temperature and this allows the semiconductor elements to be stacked without applying an excessively high temperature during the stacking step.

It is more preferable for the total amount of the diamine residue (A1) and the diamine residue (A2) to account for 75.0 mol% or more and 95.0 mol% or less, more preferably 80.0 mol% or more and 90.0 mol% or less, of all diamine residues, which account for 100.0 mol%, in the polyimide copolymer (A). If the total amount of the diamine residue (A1) and the diamine residue (A2) accounts for 80.0 mol% or more, it allows the semiconductor elements to be stacked at room temperature. If the total amount of the diamine residue (A1) and the diamine residue (A2) accounts for 90.0 mol% or less, it serves to prevent the film from becoming too soft at room temperature, resulting in a high handleability of the substrate after forming a pressure sensitive adhesive layer.

Furthermore, if the total amount of the diamine residue (A1) and the diamine residue (A2) is in the aforementioned range relative to all diamine residues, which account for 100.0 mol%, in the polyimide copolymer (A), a molar ratio between the diamine residue (A1) and the diamine residue (A2) in the range of 5:1 to 30:1 serves to achieve a suitable adhesiveness for holding the semiconductor elements.

The values of n in the formula (1) and their proportions can be determined from measurements of the molecular weights of the diamines that correspond to the monomers of the diamine residue (A1) and the diamine residue (A2). The molecular weight of a diamine can be determined by gel permeation chromatography. A molecular weight curve is drawn based on measurements of gel permeation chromatography and the weight ratios of various diamines in the diamine specimen that correspond to different n values are calculated from the proportions of sliced areas for different molecular weights. The molar fractions of various diamines with different molecular weights can be calculated from the measured weight proportions divided by the corresponding molecular weights. The diamines are incorporated into the polyimide copolymer (A) as they are polymerized, and therefore, the proportions of the diamine residue (A1) and the diamine residue (A2) contained in the polyimide copolymer (A) can be considered to be equal to the n values and their proportions determined from analysis of the molecular weights of the diamines that correspond to the monomers of the diamine residue (A1) and the diamine residue (A2).

Examples of the diamine residue (A1) and the diamine residue (A2) include residues derived from α,ω-bis(3-aminopropyl)polydimethyl siloxane, α,ω-bis(3-aminopropyl)polydiethyl siloxane, α,ω-bis(3-aminopropyl)polydipropyl siloxane, α,ω-bis(3-aminopropyl)polydibutyl siloxane, α,ω-bis(3-aminopropyl)polydiphenoxy siloxane, α,ω-bis(2-aminoethyl)polydimethyl siloxane, α,ω-bis(2-aminoethyl)polydiphenoxy siloxane, α,ω-bis(4-aminobutyl)polydimethyl siloxane, α,ω-bis(4-aminobutyl)polydiphenoxy siloxane, α,ω-bis(5-aminopentyl)polydimethyl siloxane, α,ω-bis(5-aminopentyl)polydiphenoxy siloxane, α,ω-bis(4-aminophenyl)polydimethyl siloxane, and α,ω-bis(4-aminophenyl)polydiphenoxy siloxane.

In addition, the polyimide copolymer that is present in the pressure sensitive adhesive according to the present invention further includes a diamine residue (A3) having a phenolic hydroxyl group. If such a diamine residue (A3) is included, a crosslinked structure formed through its reaction with a dimer acid modified epoxy resin (B) is introduced to ensure an increased cohesive strength of the pressure sensitive adhesive, and as a result, breakage of the pressure sensitive adhesive is reduced during the step for detaching the semiconductor elements held on the pressure sensitive adhesive, thereby preventing the pressure sensitive adhesive from remaining on the surface of the semiconductor elements. Hereinafter, the remains of the pressure sensitive adhesive left after detaching the semiconductor elements will be referred to as "adhesive residue".

It is preferable for the diamine residue (A3) to account for 1.0 mol% or more and 30.0 mol% or less of all diamine residues, which account for 100.0 mol%, in the polyimide copolymer (A). This works to enhance the effect of reducing the adhesive residue as a crosslinked structure is formed through the reaction with a dimer acid modified epoxy resin (B) while stably holding the semiconductor elements. It is more preferable for the diamine residue (A3) to account for 5.0 mol% or more and 20.0 mol% or less of all diamine residues, which account for 100.0 mol%, in the polyimide copolymer (A). If the diamine residue (A3) that is present in the polyimide copolymer (A) accounts for 5.0 mol% or more of all diamine residues, which account for 100.0 mol%, in the polyimide copolymer (A), it serves to ensure uniform crosslinking over the film surface, thereby further reducing the adhesive residue and improving the chemical resistance. Furthermore, if the diamine residue (A3) present in the polyimide copolymer (A) accounts for 20.0 mol% or less of all diamine residues, which account for 100.0 mol%, in the polyimide copolymer (A), it serves to hold the semiconductor elements stably.

Specific examples of the diamine residue (A3) to use for the present invention include residues derived from 2,5-diaminophenol, 3,5-diaminophenol, 3,3'-dihydroxybenzidine, 2,2-bis(3-amino-4-hydroxyphenyl) propane, 2,2-bis(3-amino-4-hydroxyphenyl) hexafluoropropane, 4,4'-dihydroxy-3,3'-diaminodiphenyl sulfone, 4,4'-dihydroxy-3,3'-diaminodiphenyl ether, 3,3'-dihydroxy-4,4'-diaminodiphenyl ether, 4,4'-dihydroxy-3,3'-diaminodiphenyl methane, 4,4'-dihydroxy-3,3'-diaminobenzophenone, 1,3-bis(4-amino-3-hydroxyphenyl) benzene, 1,3-bis(3-amino-4-hydroxyphenyl) benzene, bis(4-(4-amino-3-hydroxyphenoxy)benzene) propane, bis(4-(3-amino-4-hydroxyphenoxy)benzene) sulfone, and bis(4-(3-amino-4-hydroxyphenoxy))biphenyl.

Furthermore, the polyimide copolymer (A) may also include diamine residues other than the diamine residue (A1), the diamine residue (A2), and the diamine residue (A3). It is preferable for such diamine residues other than the diamine residue (A1), the diamine residue (A2), and the diamine residue (A3) to account for 0.1 mol% or more and 40.0 mol% or less of all diamine residues, which account for 100.0 mol%, in the polyimide copolymer (A).

Specific examples of good diamine residues other than the diamine residue (A1), the diamine residue (A2), and the diamine residue (A3) include those derived from p-phenylenediamine, m-phenylenediamine, 2,5-diaminotoluene, 2,4-diaminotoluene, 3,5-diaminobenzoic acid, 2,6-diaminobenzoic acid, 2-methoxy-1,4-phenylenediamine, 4,4'-diaminobenzanilide, 3,4'-diaminobenzanilide, 3,3'-diaminobenzanilide, 3,3'-dimethyl-4,4'-diaminobenzanilide, 9,9-bis(4-aminophenyl)fluorene, 9,9-bis(3-aminophenyl)fluorene, 9,9-bis(3-methyl-4-aminophenyl)fluorene, 9,9-bis(3,5-dimethyl-4-aminophenyl)fluorene, 9,9-bis(3-methoxy-4-aminophenyl)fluorene, 9,9-bis(4-aminophenyl)fluorene-4-carboxylic acid, 9,9-bis(4-aminophenyl)fluorene-4-methyl, 9,9-bis(4-aminophenyl)fluorene-4-methoxy, 9,9-bis(4-aminophenyl)fluorene-4-ethyl, 9,9-bis(4-aminophenyl)fluorene-4-sulfone, 9,9-bis(4-aminophenyl)fluorene-3-carboxylic acid, 9,9-bis(4-aminophenyl)fluorene-3-methyl, 1,3-diaminocyclohexane, 2,2'-dimethylbenzidine, 3,3'-dimethylbenzidine, 3,3'-dimethoxybenzidine, 2,4-diaminopyridine, 2,6-diaminopyridine, 1,5-diaminonaphthalene, 2,7-diaminofluorene, p-aminobenzylamine, m-aminobenzylamine, 4,4'-bis(4-aminophenoxy)biphenyl, 4,4'-diaminodiphenyl ether, 3,3'-diaminodiphenyl ether, 3,4'-diaminodiphenyl ether, 4,4'-diaminodiphenyl sulfone, 3,3'-diaminodiphenyl sulfone, 3,3'-diaminodiphenyl methane, 4,4'-diaminodiphenyl methane, 4,4'-diaminodiphenyl sulfide, 3,3'-diaminobenzophenone, 3,4'-diaminobenzophenone, 4,4'-diaminobenzophenone, 3,3'-dimethyl-4,4'-diaminodiphenyl methane, 1,3-bis(4-aminophenoxy)benzene, 1,3-bis(3-aminophenoxy)benzene, 1,4-bis(4-aminophenoxy)benzene, 1,4-bis(3-aminophenoxy)benzene, 2,2-bis[4-(4-aminophenoxy)phenyl] propane, 2,2-bis[4-(3-aminophenoxy)phenyl] propane, bis[4-(4-aminophenoxy)phenyl] methane, bis[4-(3-aminophenoxy)phenyl] methane, bis[4-(4-aminophenoxy)phenyl] ether, bis[4-(3-aminophenoxy)phenyl] ether, bis[4-(4-aminophenoxy)phenyl] sulfone, bis[4-(3-aminophenoxy)phenyl] sulfone, 2,2-bis[4-(4-aminophenoxy)phenyl] hexafluoropropane, 1,4-diaminocyclohexane, 4,4'-methylenebis(cyclohexylamine), 3,3'-methylenebis(cyclohexylamine), 4,4'-diamino-3,3'-dimethyldicyclohexyl methane, 4,4'-diamino-3,3'-dimethyldicyclohexyl, and benzidine. The diamine residues listed above may be contained singly or as a combination of two or more thereof.

The polyimide copolymer (A) contains an acid anhydride residue and preferably contains a residue of an aromatic tetracarboxylic dianhydride. The acid dianhydride residue contained may be a residue of a generally known acid dianhydride. Specific examples of residues of such aromatic tetracarboxylic dianhydrides include those derived from pyromellitic dianhydride, 3,3',4,4'-biphenyl tetracarboxylic dianhydride, 2,2'-dimethyl-3,3',4,4'-biphenyl tetracarboxylic dianhydride, 5,5'-dimethyl-3,3',4,4'-biphenyl tetracarboxylic dianhydride, 2,3,3',4'-biphenyl tetracarboxylic dianhydride, 2,2',3,3'-biphenyl tetracarboxylic dianhydride, 3,3',4,4'-diphenyl ether tetracarboxylic dianhydride, 2,3,3',4'-diphenyl ether tetracarboxylic dianhydride, 2,2',3,3'-diphenyl ether tetracarboxylic dianhydride, 3,3',4,4'-benzophenone tetracarboxylic dianhydride, 2,2',3,3'-benzophenone tetracarboxylic dianhydride, 2,3,3',4'-benzophenone tetracarboxylic dianhydride, 3,3',4,4'-diphenyl sulfone tetracarboxylic dianhydride, 2,3,3',4'-diphenyl sulfone tetracarboxylic dianhydride, 3,3',4,4'-diphenyl sulfoxide tetracarboxylic dianhydride, 3,3',4,4'-diphenyl sulfide tetracarboxylic dianhydride, 3,3',4,4'-diphenyl methylene tetracarboxylic dianhydride, 4,4'-isopropylidene diphthalic dianhydride, 4,4'-(hexafluoroisopropylidene) diphthalic dianhydride, 3,4,9,10-perylene tetracarboxylic dianhydride, 2,3,6,7-naphthalene tetracarboxylic dianhydride, 1,4,5,8-naphthalene tetracarboxylic dianhydride, 1,2,5,6-naphthalene tetracarboxylic dianhydride, 3,3",4,4"-para-terphenyl tetracarboxylic dianhydride, 3,3",4,4"-meta-terphenyl tetracarboxylic dianhydride, 2,3,6,7-anthracene tetracarboxylic dianhydride, and 1,2,7,8-phenanthrene tetracarboxylic dianhydride. The aromatic tetracarboxylic dianhydride residues listed above may be contained singly or as a combination of two or more thereof.

For the present invention, furthermore, the polyimide copolymer (A) may contain a residue of a tetracarboxylic dianhydride having an aliphatic ring as long as it does not impair the heat resistance of the polyimide copolymer (A). Specific examples of such a residue of a tetracarboxylic dianhydride having an aliphatic ring include residues derived from 2,3,5-tricarboxycyclopentyl acetic dianhydride, 1,2,3,4-cyclobutane tetracarboxylic dianhydride, 1,2,3,4-cyclopentane tetracarboxylic dianhydride, 1,2,4,5-bicyclohexene tetracarboxylic dianhydride, 1,2,4,5-cyclohexane tetracarboxylic dianhydride, and 1,3,3a,4,5,9b-hexahydro-5-(tetrahydro-2,5-dioxo-3-furanyl)-naphtho[1,2-C]furan-1,3-dione. The tetracarboxylic dianhydride residues listed above may be contained singly or as a combination of two or more thereof.

The molecular weight of the polyimide copolymer (A) can be adjusted properly by using equimolar amounts of the acid anhydride component and the diamine component in the synthesis process or by adding either of them in excess of the other. It may also be good to add either of the acid anhydride component or the diamine component in excess of the other, with the polymer chain ends being capped with an end capping agent for the acid component or amine component. Dicarboxylic acids or their anhydrides are preferably used as end capping agents for acid components while monoamines are preferably used as end capping agents for amine components. In this case, it is preferable that the acid equivalent number of the tetracarboxylic acid component and the amine equivalent number of the diamine component, including the end capping agent for the acid component or the amine component, to be equal to each other.

A generally known monoamine can be used as the end capping agent for an amine component, and good examples thereof include aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-carboxy-6-aminonaphthalene, 3-amino-4,6-dihydroxypyrimidine, 2-aminophenol, 3-aminophenol, and 4-aminophenol. Two or more of these end capping agents for amine components may be used in combination.

As such an end capping agent for an acid component, good examples of monocarboxylic acids, monoacid chloride compounds, and monoactive ester compounds include acid anhydrides such as phthalic anhydride, maleic anhydride, nadic anhydride, and cyclohexane dicarboxylic anhydride; monocarboxylic acid compoinds such as 3-carboxyphenol, 4-carboxyphenol, and 1-hydroxy-6-carboxynaphthalene and monoacid chloride compounds formed therefrom by modifying the carboxyl group into acid chloride; monoacid chloride compounds formed from dicarboxylic acid compounds such as terephthalic acid, phthalic acid, maleic acid, cyclohexane dicarboxylic acid, 1,5-dicarboxynaphthalene, and 1,6-dicarboxynaphthalene by modifying only either carboxyl group into acid chloride; and active ester compounds formed though a reaction of a monoacid chloride compound with N-hydroxybenzotriazole, imidazole, or N-hydroxy-5-norbornene-2,3-dicarboxyimide. Two or more of these end capping agents for acid components may be used in combination.

The molar ratio of the acid dianhydride component to the diamine component in the polyimide copolymer (A) can be adjusted appropriately so that the resulting resin composition has a viscosity that facilitates easy use in operations such as coating, but in general, the molar ratio of the acid dianhydride component to the diamine component is adjusted in the range of 100/100 to 100/95 or 100/100 to 95/100. If the molar ratio of the acid dianhydride component to the diamine component in the polyimide copolymer (A) is changed largely out of the above range by adding either component significantly in excess of the other, it will lead to a resin having a decreased molecular weight, and the resulting film will have a poor mechanical strength to cause an uneven distribution of adhesion strength. Therefore, it is preferable to adjust the molar ratio in a range where an appropriate adhesion strength can be maintained stably.

The polyimide copolymer (A) may be a polyimide precursor that can be cyclized by heating to form a polyimide copolymer, or a polyimide copolymer formed through cyclization caused by heating, or a polyimide precursor that has been partly cyclized into a polyimide copolymer.

There are no particular restrictions on the method to use for polymerizing the polyimide copolymer (A). To polymerize a polyamic acid that can serve as a polyimide precursor, for example, an acid dianhydride and a diamine are stirred in a solvent at 0°C to 100°C for 1 to 100 hours to prepare a polyamic acid resin solution. In the case where the intended polyimide resin will be soluble in the solvent, the polymerized polyamic acid is immediately heated to a temperature of 120°C to 300°C and stirred for 1 to 100 hours so that it is converted into a polyimide, thus obtaining a polyimide resin solution. During this step, toluene, o-xylene, m-xylene, p-xylene, etc., may be added to the reaction solution so that the water generated from the imidization reaction is removed by azeotropic distillation with these solvents.

The pressure sensitive adhesive according to the present invention further contains a dimer acid epoxy resin (B) as an essential component. A dimer acid modified epoxy resin has a structure formed by epoxidizing the molecular ends of a dimer acid and has a flexible backbone. The dimer acid epoxy resin (B) undergoes a crosslinking reaction with the phenolic hydroxyl group present in the polyimide copolymer (A) to cause crosslinking in the polyimide copolymer (A) in the pressure sensitive adhesive, and as a result, breakage of the pressure sensitive adhesive is reduced during the step for detaching the semiconductor elements held on the pressure sensitive adhesive, thereby preventing the occurrence of adhesive residue. In addition, the crosslinking of the polyimide copolymer (A) serves to enhance the chemical resistance. For the present invention, the dimer acid modified epoxy resin (B) in use is particularly high in flexibility to facilitate crosslinking without reducing the film's flexibility, and accordingly, a pressure sensitive adhesiveness suitable for holding semiconductor elements can be maintained even after the crosslinking reaction.

It is preferable for the pressure sensitive adhesive according to the present invention to further include 5 parts by weight or more and 50 parts by weight or less of a dimer acid modified epoxy resin (B) relative to 100 parts by weight of the polyimide copolymer (A). If the content of the dimer acid modified epoxy resin (B) is in this range, it serves to further reduce the amount of the adhesive residue and enhance the chemical resistance. It is more preferable to include 5 parts by weight or more and 30 parts by weight or less of a dimer acid modified epoxy resin (B) relative to 100 parts by weight of the polyimide copolymer (A). If the content of the dimer residue-modified epoxy resin (B) is in this range, it will form a crosslinked structure effectively with the polyimide copolymer (A), thereby ensuring a higher heat resistance.

The dimer acid modified epoxy resin (B) is produced by forming a dibasic acid through the dimerization of an unsaturated fatty acid and introducing a glycidyl group into it, and preferable examples of unsaturated fatty acid to use as material for the dimer acid modified epoxy resin include higher unsaturated fatty acids containing 11 to 22 carbon atoms. Examples of such higher unsaturated fatty acids include oleic acid, elaidic acid, octadecenoic acid, linoleic acid, palmitoleic acid, myristoleic acid, linolenic acid, isoleic acid, eicosenoic acid, docosenoic acid, branched octadecenoic acid, branched hexadecenoic acid, and undecylenic acid. Other examples include those produced by introducing a glycidyl group into a dimerized linolenic acid, such as, but not limited to, JER871, JER872 (both trade names, manufactured by Mitsubishi Chemical Corporation), and ERISYS GS-120 (trade name, manufactured by CVC).

The pressure sensitive adhesive according to the present invention may contain a curing accelerating agent as required in order to promote the curing of the polyimide copolymer (A) and the dimer acid modified epoxy resin (B).

Examples of such a curing accelerating agent include imidazoles, tertiary amines, salts thereof, and organic boron salt compounds, of which imidazoles are preferable. Specific examples of imidazoles include imidazole, 2-methyl imidazole, 2-ethyl imidazole, 2-isopropyl imidazole, 2-n-propyl imidazole, 1,2-dimethyl imidazole, 2-ethyl-4-methyl imidazole, 2-phenyl-1H-imidazole, 4-methyl-2-phenyl-1H-imidazole, 2-phenyl-4-methyl imidazole, 1-benzyl-2-methyl imidazole, 1-cyanoethyl-2-methyl imidazole, 1-cyanoethyl-2-ethyl- 4-methyl imidazole, 2-phenyl-4,5-dihydroxymethyl imidazole, 2-phenyl-4-methyl-5-hydroxymethyl imidazole, 1-cyanoethyl-2-phenyl-4,5-di(2-cyanoethoxy)methyl imidazole, 1-dodecyl-2-methyl-3-benzyl imidazolium chloride, 1-benzyl-2-phenyl imidazole hydrochloride, and 1-benzyl-2-phenyl imidazolium trimellitate. In addition, examples of commercially available products of preferable imidazoles include Curezol C17Z, Curezol 2MZ, Curezol 1B2MZ, Curezol 2E4MZ, Curezol 2E4MZ-CN, Curezol 2MZ-AZINE, and Curezol 2MZ-OK (all trade names, manufactured by Shikoku Chemicals Corporation).

The curing accelerating agent added preferably accounts for 0.1 part by weight or more and 5.0 parts by weight or less relative to 100 parts by weight of the polyimide copolymer (A). It is more preferable for the curing accelerating agent added to account for 0.5 part by weight or more and 2.0 parts by weight or less relative to 100 parts by weight of the polyimide copolymer (A). If the content of the curing accelerating agent added is in this range, it serves sufficiently in accelerating the crosslinking reaction to allow the pressure sensitive adhesive to work stably.

In addition, it is preferable for the pressure sensitive adhesive according to the present invention to further include a crosslinking agent (C) having an alkoxy methyl group or a methylol group. If an alkoxy methyl group or a methylol group is contained in the crosslinking agent (C), it serves to increase the chemical resistance. If the pressure sensitive adhesive layer has a sufficiently high chemical resistance, it serves to allow the pressure sensitive adhesive layer to pass through chemical treatment steps with semiconductor elements held thereon. It is preferable for the crosslinking agent (C) that has an alkoxy methyl group or a methylol group to account for 0.1 part by weight or more and 5.0 parts by weight or less relative to 100 parts by weight of the polyimide copolymer (A). For the crosslinking agent (C) that has a methylol group, it is more preferable to account for 0.5 part by weight or more relative to 100 parts by weight of the polyimide copolymer (A). As the upper limit, it is more preferable to account for 3.0 parts by weight or less relative to 100 parts by weight of the polyimide copolymer (A) and it is still more preferable to account for 1.5 parts by weight or less relative to 100 parts by weight of the polyimide copolymer (A).

Examples of the crosslinking agent (C) having an alkoxymethyl group or an methylol group include substances having structures as described below.

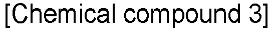

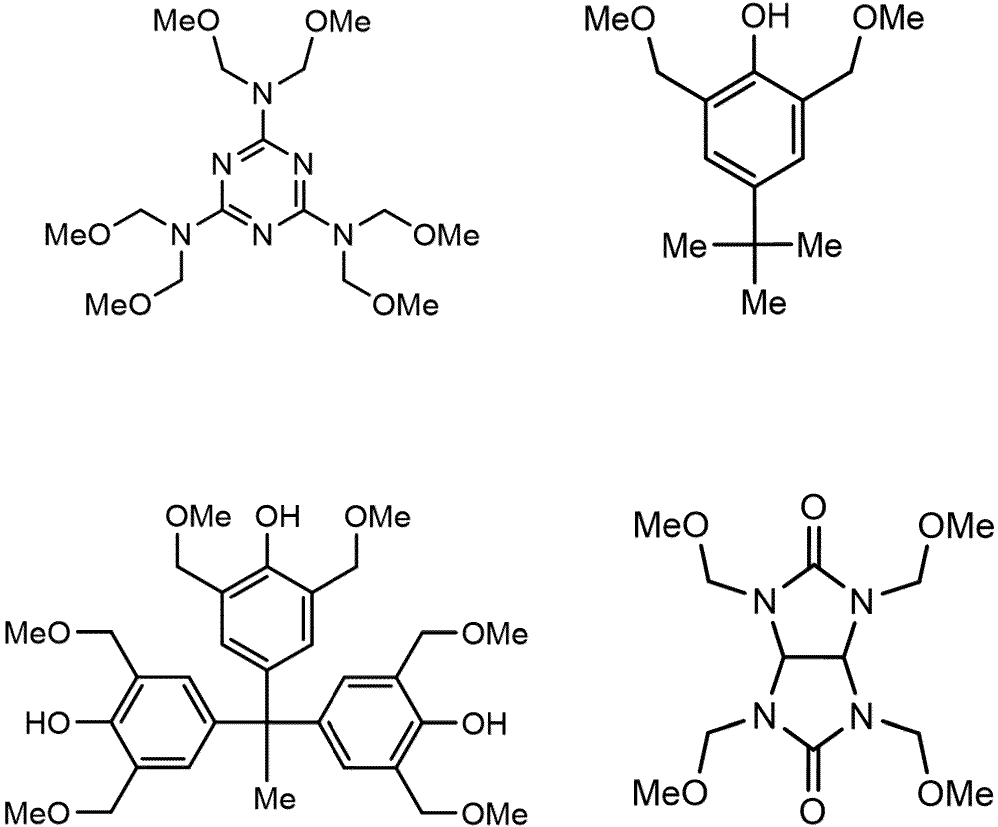

In the formula, Me represents a methyl group.

In addition, good commercially available products include DML-PC, DML-PEP, DML-OC, DML-OEP, DML-34X, DML-PTBT, DML-PCHP, DML-OCHP, DML-PFP, DML-PSBT, DML-POP, DML-MBOC, DML-MBPC, DML-MTrisPC, DML-BisOC-Z, DML-BisOCHP-Z, CML-BCP, DML-BisOC-P, DMOM-PC, DMOM-PTBT, DMOM-MBPC, TriML-P, TriML-35XL, TML-HQ, TML-BP, TML-pp-BPF, TML-BPE, TML-HQ, TML-BP, TML-pp-BPF, TML-BPE, TML-BPA, TML-BPAF, TML-PBAP, TMOM-BPAP, HML-TPPHBA, HML-TPHAP, HMOM-TPPHAB, HMOM-TPHAP (all trade names, manufactured by Honshu Chemical Industry Co., Ltd.), NIKALAC (registered trade name) MX-290, NIKALAC MX-280, NIKALAC MX-270, NIKALAC MX-279, NIKALAC MW-100LM, and NIKALAC MX-750LM (all trade names, available from Sanwa Chemical Co., Ltd.).

In addition, the pressure sensitive adhesive according to the present invention may further include an imidization accelerating agent. When the polyimide copolymer (A) is a polyamic acid resin, the use of an imidization accelerating agent serves to convert it into a polyimide resin by shorter heating at a lower temperature. The conversion of the polyamic acid resin into a polyimide resin improves the heat resistance.

Specific examples of such imidization accelerating agents include, but not limited to, pyridine, trimethylpyridine, β-picoline, quinoline, isoquinoline, imidazole, 2-methyl imidazole, 1,2-dimethyl imidazole, 2-phenyl imidazole, 2,6-lutidine, triethylamine, m-hydroxybenzoic acid, 2,4-dihydroxybenzoic acid, p-hydroxyphenyl acetic acid, 4-hydroxyphenyl propionic acid, p-phenolsulfonic acid, and p-aminobenzoic acid.

It is preferable for the imidization accelerating agent to account for 3 parts by weight or more and 10 parts by weight or less relative to 100 parts by weight of the polyimide copolymer (A). If the content of the imidization accelerating agent is in this range, imidization can be completed by heat treatment performed even at a lower temperature, and the amount of the imidization accelerating agent remaining in the resin layer after heat treatment can be minimized, thereby suppressing the generation of volatiles. The imidization accelerating agent may be added during the polymerization of the polyimide copolymer (A) or after the polymerization.

Described next will be a substrate coated with a pressure sensitive adhesive layer that includes a support substrate having thereon a layer of the pressure sensitive according to the present invention.

The substrate coated with a pressure sensitive adhesive layer according to the present invention is a substrate coated with a pressure sensitive adhesive layer that includes a pressure sensitive adhesive layer made of a pressure sensitive adhesive laid on a support substrate. The substrate coated with a pressure sensitive adhesive layer has a layer of the pressure sensitive adhesive according to the present invention in the form of a film laid on either surface of a support substrate, and there may exist another layer between the support substrate and the pressure sensitive adhesive layer.

There are no particular limitations on the support substrate, but good examples thereof include substrates such as glass, quartz, silicon wafer, sapphire substrate, ceramic substrate, metal substrate, semiconductor substrate, and ceramic substrate as well as circuit boards that have circuit component materials arranged on these substrates. From the viewpoint of the handling of the substrate, it is preferable for the support substrate to have a thickness of 0.3 mm or more and 5 mm or less.

In the case where a circuit board is adopted as the support substrate, examples of materials to use for producing the circuit components include conductors containing metals such as silver, gold, copper, and aluminum, resistors containing inorganic oxides, low dielectric materials containing glass based materials and/or resins, high dielectric materials containing resins, high dielectric inorganic particles, etc., and insulators containing glass based materials. In addition, the circuit board may have an anisotropic conducting film (AFC) formed beforehand on the surface thereof, or bumps may be provided at junctions with semiconductor elements.

It is preferable for the pressure sensitive adhesive layer formed on a support substrate to have a thickness of 1.0 µm or more and 10 µm or less. If the pressure sensitive adhesive layer has a thickness of 0.1 µm or more, it serves to allow the semiconductor elements to be held securely on the pressure sensitive adhesive layer. On the other hand, if the pressure sensitive adhesive layer has a thickness of 10 µm or less, it serves to reduce the unevenness in the plane of the pressure sensitive adhesive layer to allow the semiconductor elements to be held evenly. It is more preferable for the pressure sensitive adhesive layer to have a thickness in the range of 0.5 µm or more and 7 µm or less. If the pressure sensitive adhesive layer has a thickness of 0.5 µm or more, it serves to reduce defective adhesion due to catching of foreign objects during the step for laying semiconductor elements on the surface of the pressure sensitive adhesive layer. On the other hand, if the pressure sensitive adhesive layer has a thickness of 7 µm or less, it serves to prevent the semiconductor elements from being buried in the pressure sensitive adhesive layer.

The thickness of a pressure sensitive adhesive layer can be measured by using a scanning electron microscope, optical film thickness meter, step profiler, laser microscope, etc.

A good method to form a pressure sensitive adhesive layer in the form of a film on a support substrate is to dilute the pressure sensitive adhesive according to the present invention with a solvent to prepare a varnish and apply it to a support substrate. Good examples of the solvent to use for varnish preparation include, but not limited to, polar aprotic solvents such as γ-butyrolactone; ethers such as ethylene glycol monomethyl ether, ethylene glycol monoethyl ether, ethylene glycol mono-n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, tripropylene glycol monomethyl ether, tripropylene glycol monoethyl ether, tetrahydrofuran, and dioxane; ketones such as acetone, methyl ethyl ketone, diisobutyl ketone, cyclohexanone, cyclopentanone, 2-heptanone, 3-heptanone, and diacetone alcohol; esters such as ethylene glycol monomethyl ether acetate, ethylene glycol monoethyl ether acetate, diethylene glycol monomethyl ether acetate, diethylene glycol monoethyl ether acetate, propylene glycol monomethyl ether acetate, propylene glycol monoethyl ether acetate, ethyl lactate, ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutanoate, 3-methoxybutyl acetate, 3-methyl-3-methoxybutyl acetate, 3-methyl-3-methoxybutyl propionate, ethyl acetate, n-propyl acetate, i-propyl acetate, n-butyl acetate, i-butyl acetate, n-pentyl formate, i-pentyl acetate, n-butyl propionate, ethyl butyrate, n-propyl butyrate, i-propyl butyrate, n-butyl butyrate, methyl pyruvate, ethyl pyruvate, n-propyl pyruvate, methyl acetoacetate, ethyl acetoacetate, and ethyl 2-oxobutanoate; aromatic hydrocarbons such as toluene and xylene; and amide compounds such as N-methyl pyrrolidone, N,N-dimethyl formamide, and N,N-dimethyl acetamide.

Of these, cyclohexanone, dipropylene glycol dimethyl ether, dipropylene glycol methyl-n-propyl ether, diethylene glycol methyl ethyl ether, diethylene glycol dimethyl ether, etc., are particularly preferable because of being high in solubility in the polyimide copolymer (A).

A plurality of these solvents may be used as a mixture as long as they do not impair the effects of storage stability and solubility of the polyimide copolymer (A).

Furthermore, in the aforementioned process for polymerizing the polyimide copolymer (A), the solvent adopted as the polymerization solvent may be used as the solvent for varnish preparation without removing it from the polymerization solution.

The amount of the solvent to use for diluting the pressure sensitive adhesive may be adjusted appropriately depending on the film thickness of the pressure sensitive adhesive layer to be formed and the coating method to be applied, but it is preferably 30 parts by weight or more and 1,000 parts by weight or less relative to 100 parts by weight of the polyimide copolymer (A).

Good methods to use for spreading varnish over a support substrate include spin coating using a spinner, spray coating, roll coating, screen printing, and other coating techniques using a blade coater, die coater, calender coater, meniscus coater, bar coater, roll coater, comma roll coater, gravure coater, screen coater, slit die coater, or the like.

The pressure sensitive adhesive layer formed on a support substrate by a technique as listed above is preferably heat-treated subsequently. When the polyimide copolymer (A) is a polyamic acid resin, it can be converted into a polyimide resin by heat treatment. Useful tools for heat treatment include oven, hot plate, and infrared light. Here, the drying temperature and the drying time are preferably higher than the temperature necessary to evaporate the solvent used for dilution and allow the polyimide copolymer (A) and the dimer acid modified epoxy resin (B) to undergo a crosslinking reaction. Specifically, the temperature should be between 100°C and 300°C and the time period should be several minutes to several tens of minutes.

The layered body according to the present invention is a layered body that includes a substrate coated with a pressure sensitive adhesive layer and semiconductor elements held on the surface thereof where the pressure sensitive adhesive layer is exposed. A layered body including semiconductor elements held on a substrate coated with a pressure sensitive adhesive layer refers to the aforementioned one that includes a substrate coated with a pressure sensitive adhesive layer and semiconductor elements formed on the pressure sensitive adhesive layer thereof.

Examples of the semiconductor elements to use in the layered body include, but not limited to, those made of such materials as GaN, AlN, InN, InP, GaAs, Si, and SiC. There are different types of semiconductor elements such as one additionally containing other types of semiconductors stacked one on another and one containing an electrode material, sapphire substrate, glass substrate, etc., stacked one on another. There are no particular limitations on the size of the semiconductor elements, and multiple semiconductor elements may be held on the pressure sensitive adhesive layer.

In addition, it is preferable for the aforementioned layered body to have a patterned pressure sensitive adhesive layer. A patterned pressure sensitive adhesive layer can serve to decrease the amount of the pressure sensitive adhesive in portions where it is unnecessary for holding semiconductor elements and also prevent foreign objects from adhering to portions where no semiconductor elements are present. Furthermore, in the step described subsequently in which the semiconductor elements held on the pressure sensitive adhesive layer are joined to a circuit board, it serves to prevent those portions of the pressure sensitive adhesive which are not in use for holding semiconductor elements from coming into contact with the circuit board. Good methods to pattern a pressure sensitive adhesive layer include to perform dry etching, through a mask, of the pressure sensitive adhesive layer surface of a substrate coated with a pressure sensitive adhesive layer so that it is patterned, to lay semiconductor elements first on the pressure sensitive adhesive layer surface of a substrate coated with a pressure sensitive adhesive layer and then perform dry etching by making use of the semiconductor elements themselves as a mask, and to form a film of a photosensitive resist first over the pressure sensitive adhesive layer surface of a support substrate coated with a pressure sensitive adhesive layer and then perform light exposure and development of the photosensitive resist so that the pressure sensitive adhesive layer is patterned according to the pattern of the photosensitive resist.

There are no particular limitations on the method to use for laying semiconductor elements to be held on a substrate coated with a pressure sensitive adhesive layer, but good methods include to temporarily bond semiconductor elements to a substrate or a film first and then bring the semiconductor elements into contact with a substrate coated with a pressure sensitive adhesive layer according to the present invention so that they are transferred thereto, to temporarily bond semiconductor elements to a laser-transmissive substrate and then apply laser light to them through the laser-transmissive substrate so that the semiconductor elements are transferred, and to transfer semiconductor elements directly to the surface of a pressure sensitive adhesive layer using a flip-chip bonder. In this step, it is preferable that the semiconductor elements be arranged so that they are spaced according to the intended spacing for mounting them on a substrate in the next step. The optimum pressure for laying the semiconductor elements depends on the adhesive strength of the pressure sensitive adhesive layer, and an appropriate value is generally selected in the range of 0.05 MPa to 5.0 MPa. From the viewpoint of preventing the semiconductor elements from being buried in the pressure sensitive adhesive layer, the pressure used when laying them is preferably 2.0 MPa or less. Furthermore, when laying the semiconductor elements, they may be heated as required while laying them. If they are heated, it serves to decrease the elastic modulus of the pressure sensitive adhesive layer to allow the semiconductor elements to be laid under a lower pressure.

The method for producing a layered body according to the present invention preferably includes a step for placing a laser-transmissive substrate laid with semiconductor elements that has at least a laser-transmissive substrate and semiconductor elements stacked in this order and a substrate coated with a pressure sensitive adhesive layer as described above in such a manner that the surface of the former where the semiconductor elements are exposed and the surface of the latter where the pressure sensitive adhesive layer is exposed face each other, and a subsequent step for applying laser light to the laser-transmissive substrate by irradiating that surface of the laser-transmissive substrate laid with semiconductor elements which is opposite to the surface laid with the semiconductor elements so that the semiconductor elements are transferred to the substrate coated with a pressure sensitive adhesive layer.

Here, a laser-transmissive substrate laid with semiconductor elements refers to a laser-transmissive substrate that holds semiconductor elements formed directly thereon or with another layer interposed in between. A laser-transmissive substrate refers to a substrate that transmits laser beams in the wavelength range in use, and it is preferable for the laser-transmissive substrate to have an absorbance of 0.1 or less at the wavelength of the laser beam in use. Specifically, useful substrates include inorganic ones such as quartz, sapphire, alkali glass, non-alkali glass, and borosilicate glass and organic ones such as PET, aramid, polyester, polypropylene, and cycloolefin. Good methods to lay semiconductor elements on a laser-transmissive substrate include to perform epitaxial growth of a compound semiconductor on a laser-transmissive substrate to form a layer of the compound semiconductor, followed by producing semiconductor elements directly therefrom on the laser-transmissive substrate and to form another layer on a laser-transmissive substrate, followed by laying semiconductor elements thereon. Here, another layer refers to a thin metal film, a resin film, etc. In the case of a thin metal film, a good method is to perform sputtering or vapor deposition to form a thin metal film on a laser-transmissive substrate, followed by producing semiconductor elements on the thin metal film. In the case of a resin film, a good method is to form a resin film on a laser-transmissive substrate, followed by producing a layer of semiconductor elements on the resin film. Any appropriate resin film may be adopted such as of polyimide resin, polyimide siloxane resin, silicone resin, polybenzoxazole resin, and acrylic resin. If the resin present in the resin film is one having adhesiveness, it is still more preferable since it serves to lay a layer of semiconductor elements easily.

Described next will be the step for placing a laser-transmissive substrate laid with semiconductor elements that contains a laser-transmissive substrate and semiconductor elements stacked in this order and a substrate coated with a pressure sensitive adhesive layer in such a manner that the surface of the former where the semiconductor elements are exposed and the surface of the latter where the pressure sensitive adhesive layer is exposed face each other.

The laser-transmissive substrate laid with semiconductor elements and the substrate coated with a pressure sensitive adhesive layer according to the present invention are placed in such a manner that the surface of the laser-transmissive substrate laid with semiconductor elements where the semiconductor elements are held and the surface of the substrate coated with a pressure sensitive adhesive layer where the pressure sensitive adhesive layer is exposed face each other, and then the laser-transmissive substrate laid with semiconductor elements and the substrate coated with a pressure sensitive adhesive layer are fixed so that they are parallel to each other. To prevent misalignment of semiconductor elements due to their own weight during their transfer, it is preferable that the laser-transmissive substrate laid with semiconductor elements and the substrate coated with a pressure sensitive adhesive layer that face each other be disposed so that the laser-transmissive substrate laid with semiconductor elements is on top. The laser-transmissive substrate laid with semiconductor elements and the substrate coated with a pressure sensitive adhesive layer are disposed with a certain distance provided between them. The distance between the surface of the semiconductor element layer and the surface of the pressure sensitive adhesive layer may be set appropriately in consideration of the size and thickness of the semiconductor elements, generally in the range of several micrometers to several hundred micrometers. In addition, alignment marks may be made on each substrate to help the alignment of transfer positions.

Described below will be the step for applying laser light to the laser-transmissive substrate by irradiating that surface of the laser-transmissive substrate laid with semiconductor elements which is opposite to the surface where the semiconductor elements are exposed so that the semiconductor elements are transferred to the substrate coated with a pressure sensitive adhesive layer.

After disposing the laser-transmissive substrate laid with semiconductor elements and the substrate coated with a pressure sensitive adhesive layer as described above, the laser-transmissive substrate surface of the laser-transmissive substrate laid with semiconductor elements is irradiated with laser light so that the laser light is applied to the semiconductor elements through the laser-transmissive substrate. Examples of useful lasers include solid state lasers such as YAG laser, YVO₄ laser, fiber laser, and semiconductor laser, and gas lasers such as carbon dioxide laser, excimer laser, and argon laser, from which an appropriate one may be selected depending on the wavelength to be used. From the viewpoint of stability of the energy density of the laser light in use, it is preferable to adopt laser light having an energy density of 1 mJ/cm² or more, and from the viewpoint of preventing damage to the semiconductor elements and shortening the processing time, its energy density is preferably 1,000 mJ/cm² or less.

Furthermore, the substrate coated with a pressure sensitive adhesive layer may be heated when transferring the semiconductor elements. This can enhance the retention of the transferred semiconductor elements after being transferred. In the case of heating the substrate coated with a pressure sensitive adhesive layer, the temperature is preferably 100°C or less in order to prevent warping of the substrate coated with a pressure sensitive adhesive layer from being caused by heat and facilitate their transfer with high positional accuracy.

In addition, it is preferable for the aforementioned process to include a step for removing part of the pressure sensitive adhesive layer of the substrate coated with a pressure sensitive adhesive layer. In the aforementioned process, the step for removing part of the pressure sensitive adhesive layer may be performed either before the transfer of the semiconductor elements to the substrate coated with a pressure sensitive adhesive layer or after their transfer. Specific methods useful for removing the pressure sensitive adhesive layer before transferring the semiconductor elements or removing the pressure sensitive adhesive layer after transferring the semiconductor elements are as described previously.

The production method for a semiconductor device according to the present invention will be described next.

The production method for a semiconductor device according to the present invention is a method for producing a semiconductor device using a layered body as described above and it includes a step for placing the layered body and a circuit board in such a manner that the surface of the former where the semiconductor elements are exposed faces the latter, followed by establishing an electric connection between the semiconductor elements and the circuit board by thermocompression bonding, and a subsequent step for removing the substrate part coated with a pressure sensitive adhesive layer present in the layered body from the semiconductor elements. Here, in regard to the semiconductor elements, the surface of the layered body where the semiconductor elements are exposed refers to the surface that is opposite to the surface where the semiconductor elements are held on the pressure sensitive adhesive layer.

The description of the circuit board that faces the surface of the layered body where semiconductor elements are exposed is basically the same as the description given above in relation to circuit boards.

Described next will be the step for placing the layered body and the circuit board in such a manner that the surface of the former where the semiconductor elements are exposed faces the latter and establishing an electric connection between the semiconductor elements and the circuit board by thermocompression bonding. The electric connection between the semiconductor elements and the circuit board can be established by using such a tool as semiconductor mounting bonder and wafer bonder.

To dispose the semiconductor element surface of the layered body so that it faces the circuit board, the layered body is attached to the bonder head of the bonding device while the circuit board is placed on the bonder stage in such a manner that the semiconductor element surface of the layered body and the circuit surface of the circuit board are positioned so that they face each other. Alternatively, the semiconductor element surface of the layered body and the circuit surface of the circuit board may be brought into direct contact so that they face each other. When the semiconductor element surface of the layered body and the circuit board are positioned so that they face each other, alignment adjustments are made in order to ensure that the semiconductor elements are bonded at the desired positions on the circuit board.

The temperature at which the bonding is performed may be set appropriately based on the compositional features of the semiconductor elements and the circuit board to be bonded together. In particular, in the case of using a circuit board having solder bumps, it is preferable to adopt a temperature that is higher than the melting point of the solder. The pressure sensitive adhesive according to the present invention has high heat resistance, and therefore, there will be no generation of outgassing or formation of voids even when heated in the electric connection establishing step, thus achieving uniform connection of multiple semiconductor elements. The pressure used for the connection may be set appropriately in the range where the semiconductor elements can be connected without being damaged.

Described next will be the step for removing the substrate part coated with a pressure sensitive adhesive layer from the layered body connected to the circuit board. Useful methods to remove the substrate part coated with a pressure sensitive adhesive layer from the semiconductor elements electrically connected to the circuit board include the method of removing it by mechanical peeling, the method of irradiating the support substrate with laser light having an appropriate wavelength for passing through the support substrate to allow the light to be applied to the pressure sensitive adhesive layer so that ablation of the pressure sensitive adhesive layer occurs to reduce its adhesiveness and achieve the removal, and the method of removing it by dissolving the pressure sensitive adhesive layer with a solvent. Since the pressure sensitive adhesive according to the present invention has an appropriate composition so that no adhesive residues will be left, it is preferable to use the method of performing mechanical peeling for removal. Another good method is to immerse the substrate in a solvent to swell the pressure sensitive adhesive layer and then mechanically peel it off. The swelling of the pressure sensitive adhesive layer serves to soften the pressure sensitive adhesive layer, thereby allowing the substrate coated with a pressure sensitive adhesive layer to be removed without applying significant load to the semiconductor elements.

A semiconductor device as referred to for the present invention means any device that can function by making use of characteristics of semiconductor elements, and such semiconductor devices include electrooptical devices, semiconductor circuit boards, and all electronic components containing them.

The circuit board coated with a pressure sensitive adhesive layer according to the present invention is a circuit board coated with a pressure sensitive adhesive layer that includes a circuit board laid with a pressure sensitive adhesive layer made of the pressure sensitive adhesive according to the present invention. The circuit board coated with a pressure sensitive adhesive layer according to the present invention is a substrate coated with a pressure sensitive adhesive layer as described above in which the support substrate is a circuit board with the circuit surface of the circuit board being coated with a pressure sensitive adhesive layer.

To form a pressure sensitive adhesive layer on a circuit board, the same methods as described above for forming a pressure sensitive adhesive layer on a support substrate can be used. Furthermore, it is preferable for the pressure sensitive adhesive layer on the circuit board to have a thickness that is large enough to cover the steps existing on the circuit board, and an optimum thickness may be identified depending on the steps existing on the circuit board.

The present invention also provides a layered body that includes the aforementioned circuit board coated with a pressure sensitive adhesive layer, which is produced by forming a pressure sensitive adhesive layer on a circuit board, and semiconductor elements held on the surface of the pressure sensitive adhesive layer thereof. A layered body as referred to herein is one including semiconductor elements disposed on the surface of the pressure sensitive adhesive layer formed on the circuit surface of the aforementioned circuit board.

The same types of semiconductor elements as listed above for the layered body can be used as semiconductor elements for the layered body. There are no particular limitations on the size of the semiconductor elements, and multiple semiconductor elements may be held on the pressure sensitive adhesive layer.

To dispose semiconductor elements held on a circuit board coated with a pressure sensitive adhesive layer, the same method as described above for disposing semiconductor elements in a layered body can be adopted. It is preferable for the semiconductor elements to be arranged in a pattern that is designed to allow them to be connected at desired positions on the circuit board that is combined with them with a pressure sensitive adhesive layer interposed in between.

The optimum pressure used for laying the semiconductor elements depends on the adhesiveness of the pressure sensitive adhesive layer, and an appropriate value is generally selected in the range of 0.05 MPa to 5.0 MPa. From the viewpoint of preventing the semiconductor elements from being buried in the pressure sensitive adhesive layer, the pressure used when laying the semiconductor elements is preferably 2.0 MPa or less. Furthermore, when laying the semiconductor elements, they may be heated as required while laying them. If they are heated, it serves to further decrease the elastic modulus of the pressure sensitive adhesive layer so that the semiconductor elements can be laid on a circuit board coated with a pressure sensitive adhesive layer under a lower pressure.

The production method for a semiconductor device according to the present invention is a method for producing a semiconductor device using a layered body as described above and it includes a step for applying a pressure in the stacking direction to the layered body to break the pressure sensitive adhesive layer in order to bring the circuit board into contact with the semiconductor elements so that an electric connection is established between the circuit board and the semiconductor elements.

To apply a pressure in the stacking direction to the layered body, a practical method is to use such a tool as semiconductor mounting bonder and wafer bonder as in the case of establishing an electric connection between a layered body and a circuit board as described above. The pressure sensitive adhesive according to the present invention is so low in elastic modulus that when a pressure higher than a certain level is applied in the stacking direction to the layered body, the semiconductor elements can work to break the pressure sensitive adhesive layer and, as a result, the semiconductor elements and the circuit board are brought into contact with each other to establish an electric connection between the semiconductor elements and the circuit board.

The pressure to use for establishing the electric connection may be set appropriately in the range where the pressure sensitive adhesive layer can be broken while avoiding damage to the semiconductor elements. They also can be press-bonded while heating them, and the temperature at which the bonding is performed may be set appropriately based on the compositional features of the semiconductor elements and the circuit board to be bonded together. If they are heated, it serves to soften the pressure sensitive adhesive layer to allow the semiconductor elements to be laid under a lower pressure. In the case of a circuit board having solder bumps, it is necessary to melt the solder to establish an electric connection and therefore, a temperature that is higher than the melting point of the solder is adopted.

For the above semiconductor device according to the present invention, the pressure sensitive adhesive layer may be either left in the device or removed therefrom after establishing an electric connection between the semiconductor elements and the circuit board. Since the pressure sensitive adhesive according to the present invention has insulating properties, it can serve as underfill if left in the semiconductor device to work for preventing short circuits in the circuit board. If the pressure sensitive adhesive layer is to be removed, it can be removed by dissolving it with a solvent or swelling it with a solvent followed by peeling it off.

The production method for the semiconductor device according to the present invention is a method for producing a semiconductor device that includes a step for placing a layered body that includes a substrate, a pressure sensitive adhesive layer, and a plurality of semiconductor elements stacked in this order and a circuit board in such a manner that the surface of the former where the semiconductor elements are exposed faces the latter, a step for heating and press-bonding the semiconductor elements and the circuit board at a temperature of 80°C or more and less than 300°C to establish an electric connection between them, and a subsequent step for removing the pressure sensitive adhesive layer and the substrate part present in the layered body from the semiconductor elements.

Useful types of substrates are as described previously in relation to support substrates. Useful adhesive materials include films of resins such as polyimide, silicone resin, and acrylic resin and tapes such as Die Attach film. In particular, it is preferable for the pressure sensitive adhesive layer to contain polyimide. If the pressure sensitive adhesive layer contains polyimide, it serves to allow the pressure sensitive adhesive layer itself to have a largely improved heat resistance. Thus, a high heat resistance is ensured and it will be possible to perform thermocompression bonding of the semiconductor elements and the circuit boards at a high temperature.

The same description as given above can be applied to the step for placing a layered body that includes a substrate, a pressure sensitive adhesive layer, and a plurality of semiconductor elements stacked in this order and a circuit board in such a manner that the surface of the former where the semiconductor elements are exposed faces the latter.

The production method for a semiconductor device according to the present invention includes a step for press-bonding the semiconductor elements and the circuit board by heating them at 80°C or more and less than 300°C to establish an electric connection between them. The application of heat at 80°C or more serves to allow the semiconductor elements and the circuit board to be connected securely. On the other hand, if the bonding temperature is 300°C or less, it serves to achieve a connection without adversely affecting the semiconductor elements due to heat. It also includes a subsequent step for removing the pressure sensitive adhesive layer and the substrate part present in the layered body from the semiconductor elements. Useful methods for their removal are as described above.

The production method for a semiconductor device according to the present invention is a method for producing a semiconductor device that includes a step for applying a pressure in the stacking direction to the layered body having a circuit board, a pressure sensitive adhesive layer, and a plurality of semiconductor elements stacked in this order to break the pressure sensitive adhesive layer in order to bring the circuit board into contact with the semiconductor elements so that an electric connection is established between the circuit board and the semiconductor elements. Specific useful methods for carrying out the step for applying a pressure in the stacking direction to the layered body having a circuit board, a pressure sensitive adhesive layer, and a plurality of semiconductor elements stacked in this order to break the pressure sensitive adhesive layer in order to bring the circuit board into contact with the semiconductor elements so that an electric connection is established between the circuit board and the semiconductor elements are as described above.

### EXAMPLES

The present invention will be described below with reference to examples, though the present invention is not limited to these examples. First, the evaluation procedures used in the examples and comparative examples are described.

### (1) Evaluation for retention of semiconductor elements

A varnish prepared by a method as described later was spread over a 4-inch glass substrate using a spinner, prebaked on a hot plate at 120°C for 3 minutes, and then heat-cured at 225°C for 10 minutes to form a pressure sensitive adhesive layer with a thickness of about 5 µm on the silicone wafer, thereby providing a support substrate coated with a pressure sensitive adhesive layer. The thickness of the pressure sensitive adhesive layer was measured using a laser microscope (manufactured by Keyence Corporation, VK-9510).

Elsewhere, a silicon wafer with a thickness of 300 µm was prepared by polishing the rear surface of a silicon wafer and affixed to a piece of dicing tape (manufactured by Denka Company Limited, UDC-1025MC), followed by dicing it with a dicing machine (manufactured by DISCO Corporation, DAD300) to prepare dummy chips for semiconductor elements. The dummy chips prepared had a size of 500 µm × 500 µm with chip intervals of 150 µm. Then, a UV beam was applied to the dicing tape to reduce the adhesiveness of the dicing tape. Then, one hundred dummy chips arrayed in a 10 (rows) × 10 (columns) grid were selected and left while the other ones surrounding them were removed with tweezers. The pressure sensitive adhesive layer surface of the aforementioned 4-inch glass substrate was brought into contact with the dummy chips disposed on the dicing tape in such a manner that the chip surfaces face the former.

Using a vacuum laminator, a pressure of 0.6 MPa was applied for 1 minute at room temperature in order to achieve press-bonding of the dummy chips to the pressure sensitive adhesive layer. Subsequently, the dicing tape was peeled off to produce a layered body in which the pressure sensitive adhesive layer and the dummy chips were stacked in this order on the glass substrate. The surface of the pressure sensitive adhesive layer was visually observed under an optical microscope, and the number of chips retained on the pressure sensitive adhesive layer at room temperature was counted.

In addition, except that the press-bonding temperature in the vacuum laminator was set to 100°C, the same procedure as described above was carried out to produce a layer of dummy chips, and the number of chips retained at 100°C was counted.

### (2) Evaluation for adhesive residue

A varnish of a pressure sensitive adhesive prepared by a method as described later was spread over a 4-inch silicone wafer using a spinner, prebaked on a hot plate at 120°C for 3 minutes, and then heat-cured at 225°C for 10 minutes to prepare a substrate coated with a pressure sensitive adhesive layer. The thickness of the heat-cured pressure sensitive adhesive layer was measured using an optical film thickness meter (manufactured by Dainippon Screen Mfg. Co., Ltd., Lambda Ace, refractive index 1.543).

A Kapton film cut into a strip measuring 9 cm × 1 cm was put on the pressure sensitive adhesive layer surface of this substrate coated with a pressure sensitive adhesive layer and the Kapton film was press-bonded using a vacuum laminator under 0.1 MPa at 25°C. Then, the substrate having a Kapton film press-bonded thereon was put on a hot plate set to 200°C and heated for 10 minutes, A sample was set in a tensile tester (manufactured by NIDEC-SHIMPO Corporation, FGS-VC), and the press-bonded Kapton film was peeled off by pulling in the perpendicular direction to the silicone wafer at a constant speed of 2 mm/sec. Three measurements were taken from different samples. On the Kapton film surface of each peeled sample, the area where the adhesive remained attached was measured. The sample having the largest area containing adhesive residue was selected and evaluated according to the criteria A to D described below.
A: visually undetectable or less than 10%,
B: 10% or more and less than 20%,
C: 20% or more and less than 50%, and
D: 50% or more.

### (3) Evaluation for heat resistance

A varnish of a pressure sensitive adhesive prepared by the method described later was spread over a 4-inch silicone wafer using a spinner, prebaked on a hot plate at 120°C for 3 minutes, and then heat-cured at 225°C for 10 minutes. After the heat treatment, the pressure sensitive adhesive layer was scraped off with a spatula, and about 15 mg of the monolayer of the pressure sensitive adhesive was packed in an aluminum standard container and subjected to measurement using a thermogravimetric analyzer (manufactured by Shimadzu Corporation, TGA-50). In regard to the measuring conditions, the specimen was maintained at 120°C for 30 minutes and heated to 500°C at a heating rate of 5°C/min.

From the resulting weight loss curve, the temperature at which the weight loss reached 1% was identified and this temperature was adopted as the 1% weight loss temperature, followed by evaluation according to the criteria A to C described below.
A: 350°C or more,
B: 300°C or more and less than 350°C, and
C: less than 300°C.

### (4) Test and evaluation for chemical resistance

A varnish of a pressure sensitive adhesive prepared by a method as described later was spread over a 4-inch silicone wafer using a spinner, prebaked on a hot plate at 120°C for 3 minutes, and then heat-cured at 225°C for 10 minutes to prepare a substrate coated with a pressure sensitive adhesive layer having a thickness of about 5 µm. The substrate with a heat-cured pressure sensitive adhesive layer formed thereon was immersed in N-methylpyrrolidone (NMP) at 25°C for 10 minutes. After the immersion, the substrate coated with a pressure sensitive adhesive layer was taken out, rinsed with pure water, and dried on a hot plate at 120°C for 5 minutes. The thickness of this substrate was measured before and after the immersion period using an optical film thickness meter, and the thickness change rate was calculated using the following formula. Residual film rate (%) = film thickness after chemical resistance test (µm) / film thickness before chemical resistance test (µm) x 100

An evaluation was made based on the calculated residual film rate according to the criteria A to D described below.
A: 95% or more,
B: 90% or more and less than 95%,
C: 80% or more and less than 90%, and
D: less than 80%.

### (5) Measurement of solid content in polyimide copolymer solution

From a polyimide copolymer solution prepared by a method as described later, about 1 g was weighed out in an aluminum cup, heated on a hot plate at 120°C for 3 minutes, then heated up to 250°C, and, after reaching 250°C, maintained there for 30 minutes. The weight of the resin remaining after the heating was measured, and the solid content was calculated by the formula given below. Solid content (wt%) = weight of resin after heating (g) / weight of resin solution before heating (g) x 100

### <Raw materials used in production examples>

The abbreviations used in the production examples given below refer to the following acid dianhydrides, diamines, additives, and solvents.
PMDA: pyromellitic dianhydride (corresponding to acid dianhydride residue)
PA: phthalic anhydride (corresponding to end-capping agent for acid component)
APPS2: α,ω-bis(3-aminopropyl)polydimethyl siloxane with a number average molecular weight of 860 wherein 99.0 mol% of the components of APPS2 is accounted for by those represented by the formula (1) in which n is in the range of 1 to 15 (diamine residue (A1)), while the remaining 1.0 mol% is accounted for by those corresponding to n in the range 16 to 50 (diamine residue (A2)).
APPS3: α,ω-bis(3-aminopropyl)polydimethyl siloxane with a number average molecular weight of 1,550 wherein 98.5 mol% of the components of APPS3 is accounted for by those represented by the formula (1) in which n is in the range of 16 to 50 (diamine residue (A2)), while 1.0 mol% is accounted for by those corresponding to n in the range 1 to 15 (diamine residue (A1)). There are no components that correspond to n of 51 or more.
APPS4: α,ω-bis(3-aminopropyl)polydimethyl siloxane with a number average molecular weight of 3,000 wherein 98.0 mol% of the components of APPS4 is accounted for by those represented by the formula (1) in which n is in the range of 16 to 50 (diamine residue (A2)), while 1.5 mol% is accounted for by those corresponding to n in the range 1 to 15 (diamine residue (A1)). There are no components that correspond to n of 51 or more.
BAHF: 2,2-bis(3-amino-4-hydroxyphenyl) hexafluoropropane (corresponding to diamine residue (A3))
DABS: 4,4'-dihydroxy-3,3'-diaminodiphenyl sulfone (corresponding to diamine residue (A3)) ABP-N: 1,3-bis(3-aminophenoxy)benzene (not corresponding to any of diamine residues (A1) to (A3))
CHN: cyclohexanone
JER871: dimer acid modified epoxy resin (manufactured by Mitsubishi Chemical Corporation) (corresponding to dimer acid epoxy resin (B))
CG500: caldo based epoxy resin (manufactured by Osaka Gas Chemicals Co., Ltd.) 2E4MZ: 2-ethyl-4-methyl imidazole (manufactured by Shikoku Chemicals Corporation) 100LM: crosslinking agent having a methylol group as represented by the structural formula given below

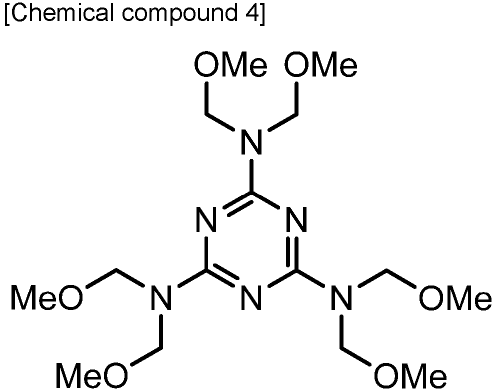

In the formula, Me represents a methyl group.

### Production example 1 (polymerization of polyimide copolymer)

In a reaction vessel equipped with a thermometer, a dry nitrogen inlet, a heating/cooling device using hot water/cooling water, and a stirring device, 95.0 g of APPS2 (containing 108.5 mmol of component A1 and 1.1 mmol of component A2), 67.7 g of APPS3 (containing 0.4 mmol of component A1 and 43.4 mmol of component A2), and 15.4 g of BAHF (corresponding to (A3), 45.8 mmol) were fed along with 225 g of CHN and dissolved, and then 5.92 g of PA (corresponding to end-capping agent for acid component, 40.0 mmol) was added, followed by stirring at 60°C for 15 minutes. Then, 39.0 g of PMDA (corresponding to acid dianhydride residue, 179.0mmol) was added, stirred at 60°C for 1 hour, heated up to 145°C, and allowed to react for 4 hours. The solid content in the resulting polyimide polymer solution was measured and found to be 51.5 wt%. CHN was added to adjust the solid content of the polymer solution to 50.0 wt%, followed by stirring to provide a polyimide copolymer solution PIS-1 that had a solid content of 50 wt%. Here, in PIS-1, the diamine residue (A1) accounts for 54.7 mol% and the diamine residue (A2) accounts for 22.3 mol% of all diamine residues, which account for 100.0 mol%, in the polyimide copolymer.

### Production example 2 (polymerization of polyimide copolymer)

Except for using 160.0 g of APPS2 (containing 182.7 mmol of component A1 and 1.8 mmol of component A2), 9.3 g of APPS3 (containing 0.1 mmol of component A1 and 6.0 mmol of component A2), 2.7 g of BAHF (corresponding to (A3), 8.0 mmol), and 217 g of CHN, the same procedure as in Production example 1 was carried out to polymerize a polyimide copolymer solution. The solid content in the resulting polyimide polymer solution was measured and found to be 50.8 wt%. CHN was added to adjust the solid content of the polymer solution to 50.0 wt%, followed by stirring to provide a polyimide copolymer solution PIS-2 that had a solid content of 50 wt%. Here, in PIS-2, the diamine residue (A1) accounts for 92.1 mol% and the diamine residue (A2) accounts for 3.9 mol% of all diamine residues, which account for 100.0 mol%, in the polyimide copolymer.

### Production example 3 (polymerization of polyimide copolymer)

Except for using 137.7 g of APPS2 (containing 157.3 mmol of component A1 and 1.6 mmol of component A2), 6.3 g of APPS3 (containing 0.04 mmol of component A1 and 4.0 mmol of component A2), 12.0 g of BAHF (corresponding to (A3), 35.8 mmol), and 202 g of CHN, the same procedure as in Production example 1 was carried out to polymerize a polyimide copolymer solution. The solid content in the resulting polyimide polymer solution was measured and found to be 51.8 wt%. CHN was added to adjust the solid content of the polymer solution to 50.0 wt%, followed by stirring to provide a polyimide copolymer solution PIS-3 that had a solid content of 50 wt%. Here, in PIS-3, the diamine residue (A1) accounts for 79.2 mol% and the diamine residue (A2) accounts for 2.8 mol% of all diamine residues, which account for 100.0 mol%, in the polyimide copolymer.

### Production example 4 (polymerization of polyimide copolymer)

Except for using 103.6 g of APPS2 (containing 118.3 mmol of component A1 and 1.2 mmol of component A2), 107.9 g of APPS3 (containing 0.7 mmol of component A1 and 69.2 mmol of component A2), 3.4 g of BAHF (corresponding to (A3), 10.0 mmol), and 260 g of CHN, the same procedure as in Production example 1 was carried out to polymerize a polyimide copolymer solution. The solid content in the resulting polyimide polymer solution was measured and found to be 52.0 wt%. CHN was added to adjust the solid content of the polymer solution to 50.0 wt%, followed by stirring to provide a polyimide copolymer solution PIS-4 that had a solid content of 50 wt%. Here, in PIS-4, the diamine residue (A1) accounts for 59.7 mol% and the diamine residue (A2) accounts for 35.3 mol% of all diamine residues, which account for 100.0 mol%, in the polyimide copolymer.

### Production example 5 (polymerization of polyimide copolymer)

Except for using 149.8 g of APPS2 (containing 171.1 mmol of component A1 and 1.7 mmol of component A2), 30.7 g of APPS3 (containing 0.2 mmol of component A1 and 19.7 mmol of component A2), 2.0 g of BAHF (corresponding to (A3), 6.0 mmol), and 228 g of CHN, the same procedure as in Production example 1 was carried out to polymerize a polyimide copolymer solution. The solid content in the resulting polyimide polymer solution was measured and found to be 50.5 wt%. CHN was added to adjust the solid content of the polymer solution to 50.0 wt%, followed by stirring to provide a polyimide copolymer solution PIS-5 that had a solid content of 50 wt%. Here, in PIS-5, the diamine residue (A1) accounts for 86.2 mol% and the diamine residue (A2) accounts for 10.8 mol% of all diamine residues, which account for 100.0 mol%, in the polyimide copolymer.

### Production example 6 (polymerization of polyimide copolymer)

Except for using 120.6 g of APPS2 (containing 137.7 mmol of component A1 and 1.4 mmol of component A2), 6.3 g of APPS3 (containing 0.04 mmol of component A1 and 4.0 mmol of component A2), 18.7 g of BAHF (corresponding to (A3), 55.7 mmol), and 192 g of CHN, the same procedure as in Production example 1 was carried out to polymerize a polyimide copolymer solution. The solid content in the resulting polyimide polymer solution was measured and found to be 50.5 wt%. CHN was added to adjust the solid content of the polymer solution to 50.0 wt%, followed by stirring to provide a polyimide copolymer solution PIS-6 that had a solid content of 50 wt%. Here, in PIS-6, the diamine residue (A1) accounts for 69.3 mol% and the diamine residue (A2) accounts for 2.7 mol% of all diamine residues, which account for 100.0 mol%, in the polyimide copolymer.

### Production example 7 (polymerization of polyimide copolymer)

Except for using 120.8 g of APPS2 (containing 137.9 mmol of component A1 and 1.4 mmol of component A2), 15.1 g of APPS3 (containing 0.1 mmol of component A1 and 9.7 mmol of component A2), 16.7 g of BAHF (corresponding to (A3), 49.8 mmol), and 199 g of CHN, the same procedure as in Production example 1 was carried out to polymerize a polyimide copolymer solution. The solid content in the resulting polyimide polymer solution was measured and found to be 51.6 wt%. CHN was added to adjust the solid content of the polymer solution to 50.0 wt%, followed by stirring to provide a polyimide copolymer solution PIS-7 that had a solid content of 50 wt%. Here, in PIS-7, the diamine residue (A1) accounts for 69.4 mol% and the diamine residue (A2) accounts for 5.6 mol% of all diamine residues, which account for 100.0 mol%, in the polyimide copolymer.

### Production example 8 (polymerization of polyimide copolymer)

Except for using 137.8 g of APPS2 (containing 157.3 mmol of component A1 and 1.6 mmol of component A2), 40.0 g of APPS3 (containing 0.3 mmol of component A1 and 25.6 mmol of component A2), 4.7 g of BAHF (corresponding to (A3), 14.0 mmol), and 228 g of CHN, the same procedure as in Production example 1 was carried out to polymerize a polyimide copolymer solution. The solid content in the resulting polyimide polymer solution was measured and found to be 53.0 wt%. CHN was added to adjust the solid content of the polymer solution to 50.0 wt%, followed by stirring to provide a polyimide copolymer solution PIS-8 that had a solid content of 50 wt%. Here, in PIS-8, the diamine residue (A1) accounts for 79.3 mol% and the diamine residue (A2) accounts for 13.7 mol% of all diamine residues, which account for 100.0 mol%, in the polyimide copolymer.

### Production example 9 (polymerization of polyimide copolymer)

Except for using 149.9 g of APPS2 (containing 171.1 mmol of component A1 and 1.7 mmol of component A2), 9.2 g of APPS3 (containing 0. mmol of component A1 and 5.9 mmol of component A2), 6.7 g of BAHF (corresponding to (A3), 19.8 mmol), and 211 g of CHN, the same procedure as in Production example 1 was carried out to polymerize a polyimide copolymer solution. The solid content in the resulting polyimide polymer solution was measured and found to be 52.0 wt%. CHN was added to adjust the solid content of the polymer solution to 50.0 wt%, followed by stirring to provide a polyimide copolymer solution PIS-9 that had a solid content of 50 wt%. Here, in PIS-9, the diamine residue (A1) accounts for 86.2 mol% and the diamine residue (A2) accounts for 3.8 mol% of all diamine residues, which account for 100.0 mol%, in the polyimide copolymer.

### Production example 10 (polymerization of polyimide copolymer)

Except for using 137.8 g of APPS2 (containing 157.3 mmol of component A1 and 1.6 mmol of component A2), 15.4 g of APPS3 (containing 0.1 mmol of component A1 and 9.9 mmol of component A2), 10.0 g of BAHF (corresponding to (A3), 29.9 mmol), and 209 g of CHN, the same procedure as in Production example 1 was carried out to polymerize a polyimide copolymer solution. The solid content in the resulting polyimide polymer solution was measured and found to be 52.8 wt%. CHN was added to adjust the solid content of the polymer solution to 50.0 wt%, followed by stirring to provide a polyimide copolymer solution PIS-10 that had a solid content of 50 wt%. Here, in PIS-10, the diamine residue (A1) accounts for 79.2 mol% and the diamine residue (A2) accounts for 5.8 mol% of all diamine residues, which account for 100.0 mol%, in the polyimide copolymer.

### Production example 11 (polymerization of polyimide copolymer)

Except for using 137.8 g of APPS2 (containing 157.3 mmol of component A1 and 1.6 mmol of component A2), 15.4 g of APPS3 (containing 0.1 mmol of component A1 and 9.9 mmol of component A2), 8.4 g of DABS instead of BAHF (corresponding to (A3), 29.9 mmol), and 206 g of CHN, the same procedure as in Production example 1 was carried out to polymerize a polyimide copolymer solution. The solid content in the resulting polyimide polymer solution was measured and found to be 52.0 wt%. CHN was added to adjust the solid content of the polymer solution to 50.0 wt%, followed by stirring to provide a polyimide copolymer solution PIS-11 that had a solid content of 50 wt%. Here, in PIS-11, the diamine residue (A1) accounts for 79.2 mol% and the diamine residue (A2) accounts for 5.8 mol% of all diamine residues, which account for 100.0 mol%, in the polyimide copolymer.

### Production example 12 (polymerization of polyimide copolymer)

Except for using 77.9 g of APPS2 (containing 89.0 mmol of component A1 and 0.9 mmol of component A2), 107.6 g of APPS3 (containing 0.27 mmol of component A1 and 69.1 mmol of component A2), 13.4 g of BAHF (corresponding to (A3), 40.0 mmol), and 246 g of CHN, the same procedure as in Production example 1 was carried out to polymerize a polyimide copolymer solution. The solid content in the resulting polyimide polymer solution was measured and found to be 50.1 wt%. CHN was added to adjust the solid content of the polymer solution to 50.0 wt%, followed by stirring to provide a polyimide copolymer solution PIS-12 that had a solid content of 50 wt%. Here, in PIS-12, the diamine residue (A1) accounts for 44.9 mol% and the diamine residue (A2) accounts for 35.1 mol% of all diamine residues, which account for 100.0 mol%, in the polyimide copolymer.

### Production example 13 (polymerization of polyimide copolymer)

Except for using 168.5 g of APPS2 (containing 192.5 mmol of component A1 and 1.9 mmol of component A2), 3.1 g of APPS3 (containing 0.02 mmol of component A1 and 2.0 mmol of component A2), 0.7 g of BAHF (corresponding to (A3), 2.0 mmol), and 217 g of CHN, the same procedure as in Production example 1 was carried out to polymerize a polyimide copolymer solution. The solid content in the resulting polyimide polymer solution was measured and found to be 53.8 wt%. CHN was added to adjust the solid content of the polymer solution to 50.0 wt%, followed by stirring to provide a polyimide copolymer solution PIS-13 that had a solid content of 50 wt%. Here, in PIS-13, the diamine residue (A1) accounts for 97.0 mol% and the diamine residue (A2) accounts for 2.0 mol% of all diamine residues, which account for 100.0 mol%, in the polyimide copolymer.

### Production example 14 (polymerization of polyimide copolymer)

Except for using 146.2 g of APPS2 (containing 167.0 mmol of component A1 and 1.7 mmol of component A2), 0.3 g of APPS3 (containing 0.01 mmol of component A1 and 0.2 mmol of component A2), 10.0 g of BAHF (corresponding to (A3), 29.8 mmol), and 202 g of CHN, the same procedure as in Production example 1 was carried out to polymerize a polyimide copolymer solution. The solid content in the resulting polyimide polymer solution was measured and found to be 52.0 wt%. CHN was added to adjust the solid content of the polymer solution to 50.0 wt%, followed by stirring to provide a polyimide copolymer solution PIS-14 that had a solid content of 50 wt%. Here, in PIS-14, the diamine residue (A1) accounts for 84.1 mol% and the diamine residue (A2) accounts for 0.9 mol% of all diamine residues, which account for 100.0 mol%, in the polyimide copolymer.

### Production example 15 (polymerization of polyimide copolymer)

Except for using 86.6 g of APPS2 (containing 98.9 mmol of component A1 and 1.0 mmol of component A2), 138.3 g of APPS3 (containing 0.9 mmol of component A1 and 88.7 mmol of component A2), 3.4 g of BAHF (corresponding to (A3), 10.1 mmol), and 274 g of CHN, the same procedure as in Production example 1 was carried out to polymerize a polyimide copolymer solution. The solid content in the resulting polyimide polymer solution was measured and found to be 54.1 wt%. CHN was added to adjust the solid content of the polymer solution to 50.0 wt%, followed by stirring to provide a polyimide copolymer solution PIS-15 that had a solid content of 50 wt%. Here, in PIS-15, the diamine residue (A1) accounts for 50.0 mol% and the diamine residue (A2) accounts for 45.0 mol% of all diamine residues, which account for 100.0 mol%, in the polyimide copolymer.

### Production example 16 (polymerization of polyimide copolymer)

Except for using 138.0 g of APPS2 (containing 157.6 mmol of component A1 and 1.6 mmol of component A2), 61.2 g of APPS3 (containing 0.4 mmol of component A1 and 39.3 mmol of component A2), none of BAHF, and 245 g of CHN, the same procedure as in Production example 1 was carried out to polymerize a polyimide copolymer solution. The solid content in the resulting polyimide polymer solution was measured and found to be 51.0 wt%. CHN was added to adjust the solid content of the polymer solution to 50.0 wt%, followed by stirring to provide a polyimide copolymer solution PIS-16 that had a solid content of 50 wt%. Here, in PIS-16, the diamine residue (A1) accounts for 79.4 mol% and the diamine residue (A2) accounts for 20.6 mol% of all diamine residues, which account for 100.0 mol%, in the polyimide copolymer.

### Production example 17 (polymerization of polyimide copolymer)

Except for using 103.7 g of APPS2 (containing 118.4 mmol of component A1 and 1.2 mmol of component A2), 15.1 g of APPS3 (containing 0.1 mmol of component A1 and 9.7 mmol of component A2), 23.4 g of BAHF (corresponding to (A3), 69.7 mmol), and 189 g of CHN, the same procedure as in Production example 1 was carried out to polymerize a polyimide copolymer solution. The solid content in the resulting polyimide polymer solution was measured and found to be 51.5 wt%. CHN was added to adjust the solid content of the polymer solution to 50.0 wt%, followed by stirring to provide a polyimide copolymer solution PIS-17 that had a solid content of 50 wt%. Here, in PIS-17, the diamine residue (A1) accounts for 59.5 mol% and the diamine residue (A2) accounts for 5.5 mol% of all diamine residues, which account for 100.0 mol%, in the polyimide copolymer.

### Production example 18 (polymerization of polyimide copolymer)

Except for using 163.3 g of APPS2 (containing 186.5 mmol of component A1 and 1.9 mmol of component A2), 6.4 g of APPS3 (containing 0.04 mmol of component A1 and 4.1 mmol of component A2), 2.0 g of BAHF (corresponding to (A3), 5.9 mmol), and 218 g of CHN, the same procedure as in Production example 1 was carried out to polymerize a polyimide copolymer solution. The solid content in the resulting polyimide polymer solution was measured and found to be 52.0 wt%. CHN was added to adjust the solid content of the polymer solution to 50.0 wt%, followed by stirring to provide a polyimide copolymer solution PIS-18 that had a solid content of 50 wt%. Here, in PIS-18, the diamine residue (A1) accounts for 94.0 mol% and the diamine residue (A2) accounts for 3.0 mol% of all diamine residues, which account for 100.0 mol%, in the polyimide copolymer.

### Production example 19 (polymerization of polyimide copolymer)

Except for using 156.4 g of APPS2 (containing 178.6 mmol of component A1 and 1.8 mmol of component A2), 23.5 g of APPS3 (containing 0.2 mmol of component A1 and 15.1 mmol of component A2), 1.0 g of BAHF (corresponding to (A3), 3.0 mmol), and 227 g of CHN, the same procedure as in Production example 1 was carried out to polymerize a polyimide copolymer solution. The solid content in the resulting polyimide polymer solution was measured and found to be 51.4 wt%. CHN was added to adjust the solid content of the polymer solution to 50.0 wt%, followed by stirring to provide a polyimide copolymer solution PIS-19 that had a solid content of 50 wt%. Here, in PIS-19, the diamine residue (A1) accounts for 90.0 mol% and the diamine residue (A2) accounts for 8.5 mol% of all diamine residues, which account for 100.0 mol%, in the polyimide copolymer.

### Production example 20 (polymerization of polyimide copolymer)

Except for using 103.6 g of APPS2 (containing 118.4 mmol of component A1 and 1.2 mmol of component A2), 15.1 g of APPS3 (containing 0.1 mmol of component A1 and 9.7 mmol of component A2), 16.7 g of BAHF (corresponding to (A3), 49.8 mmol), 5.8 g of ABP-N (diamine residue corresponding to none of (A1) to (A3), 19.9 mmol), and 187 g of CHN, the same procedure as in Production example 1 was carried out to polymerize a polyimide copolymer solution. The solid content in the resulting polyimide polymer solution was measured and found to be 50.9 wt%. CHN was added to adjust the solid content of the polymer solution to 50.0 wt%, followed by stirring to provide a polyimide copolymer solution PIS-20 that had a solid content of 50 wt%. Here, in PIS-20, the diamine residue (A1) accounts for 59.5 mol% and the diamine residue (A2) accounts for 5.5 mol% of all diamine residues, which account for 100.0 mol%, in the polyimide copolymer.

### Production example 21 (polymerization of polyimide copolymer)

Except for using 104.3 g of APPS2 (containing 117.2 mmol of component A1 and 1.2 mmol of component A2), 28.9 g of APPS4 instead of APPS3 (containing 0.1 mmol of component A1 and 9.6 mmol of component A2), 16.6 g of BAHF (corresponding to (A3), 49.2 mmol), 5.8 g of ABP-N (diamine residue corresponding to none of (A1) to (A3), 19.8 mmol), and 203 g of CHN, the same procedure as in Production example 1 was carried out to polymerize a polyimide copolymer solution. The solid content in the resulting polyimide polymer solution was measured and found to be 50.5 wt%. CHN was added to adjust the solid content of the polymer solution to 50.0 wt%, followed by stirring to provide a polyimide copolymer solution PIS-21 that had a solid content of 50 wt%. Here, in PIS-21, the diamine residue (A1) accounts for 59.5 mol% and the diamine residue (A2) accounts for 5.5 mol% of all diamine residues, which account for 100.0 mol%, in the polyimide copolymer.

### Production example 22 (polymerization of polyimide copolymer)

Except for using 121.9 g of APPS2 (containing 139.2 mmol of component A1 and 1.4 mmol of component A2), 22.4 g of APPS3 (containing 139.2 mmol of component A1 and 1.4 mmol of component A2), 12.0 g of BAHF (corresponding to (A3), 35.8 mmol), 2.3 g of ABP-N (diamine residue corresponding to none of (A1) to (A3), 8.0 mmol), and 204 g of CHN, the same procedure as in Production example 1 was carried out to polymerize a polyimide copolymer solution. The solid content in the resulting polyimide polymer solution was measured and found to be 51.2 wt%. CHN was added to adjust the solid content of the polymer solution to 50.0 wt%, followed by stirring to provide a polyimide copolymer solution PIS-22 that had a solid content of 50 wt%. Here, in PIS-22, the diamine residue (A1) accounts for 70.0 mol% and the diamine residue (A2) accounts for 8.0 mol% of all diamine residues, which account for 100.0 mol%, in the polyimide copolymer.

### Production example 23 (polymerization of polyimide copolymer)

Except for using 142.5 g of APPS2 (containing 162.8 mmol of component A1 and 1.6 mmol of component A2), 26.8 g of APPS3 (containing 0.2 mmol of component A1 and 17.2 mmol of component A2), 5.7 g of BAHF (corresponding to (A3), 17.0 mmol), and 222 g of CHN, the same procedure as in Production example 1 was carried out to polymerize a polyimide copolymer solution. The solid content in the resulting polyimide polymer solution was measured and found to be 52.0 wt%. CHN was added to adjust the solid content of the polymer solution to 50.0 wt%, followed by stirring to provide a polyimide copolymer solution PIS-23 that had a solid content of 50 wt%. Here, in PIS-23, the diamine residue (A1) accounts for 82.0 mol% and the diamine residue (A2) accounts for 9.5 mol% of all diamine residues, which account for 100.0 mol%, in the polyimide copolymer.

The mole fraction of each monomer component is listed in Table 1.

### [Table 1]

**[Table 1]**

| | Fractions (mol%) of monomers in all diamine residues (100 mol%) | | | | | | | X in formula of (A1):(A2)=X:1 |
|---|---|---|---|---|---|---|---|---|
| | acid dianhydride | chain end | diamine corresponding to diamine residue (A1) | diamine corresponding to diamine residue (A2) | diamine corresponding to diamine residue (A3) | diamine corresponding to none of A1, A2, and A3 | Sum of diamine corresponding to diamine residue (A1) and diamine corresponding to diamine residue (A2) | |
| PIS-1 | 89.5 | 20 | 54.7 | 22.3 | 23.0 | 0.0 | 77 | 2.5 |
| PIS-2 | 89.5 | 20 | 92.1 | 3.9 | 4.0 | 0.0 | 96 | 23.6 |
| PIS-3 | 89.5 | 20 | 79.2 | 2.8 | 18.0 | 0.0 | 82 | 28.3 |
| PIS-4 | 89.5 | 20 | 59.7 | 35.3 | 5.0 | 0.0 | 95 | 1.7 |
| PIS-5 | 89.5 | 20 | 86.2 | 10.8 | 3.0 | 0.0 | 97 | 8.0 |
| PIS-6 | 89.5 | 20 | 69.3 | 2.7 | 28.0 | 0.0 | 72 | 25.7 |
| PIS-7 | 89.5 | 20 | 69.4 | 5.6 | 25.0 | 0.0 | 75 | 12.4 |
| PIS-8 | 89.5 | 20 | 79.3 | 13.7 | 7.0 | 0.0 | 93 | 5.8 |
| PIS-9 | 89.5 | 20 | 86.2 | 3.8 | 10.0 | 0.0 | 90 | 22.7 |
| PIS-10 | 89.5 | 20 | 79.2 | 5.8 | 15.0 | 0.0 | 85 | 13.7 |
| PIS-11 | 89.5 | 20 | 79.2 | 5.8 | 15.0 | 0.0 | 85 | 13.7 |
| PIS-12 | 89.5 | 20 | 44.9 | 35.1 | 20.0 | 0.0 | 80 | 1.3 |
| PIS-13 | 89.5 | 20 | 97.0 | 2.0 | 1.0 | 0.0 | 99 | 48.5 |
| PIS-14 | 89.5 | 20 | 84.1 | 0.9 | 15.0 | 0.0 | 85 | 93.4 |
| PIS-15 | 89.5 | 20 | 50.0 | 45.0 | 5.0 | 0.0 | 95 | 1.1 |
| PIS-16 | 89.5 | 20 | 79.4 | 20.6 | 0.0 | 0.0 | 100 | 3.9 |
| PIS-17 | 89.5 | 20 | 59.5 | 5.5 | 35.0 | 0.0 | 65 | 10.8 |
| PIS-18 | 89.5 | 20 | 94.0 | 3.0 | 3.0 | 0.0 | 97 | 31.3 |
| PIS-19 | 89.5 | 20 | 90.0 | 8.5 | 1.5 | 0.0 | 98.5 | 10.6 |
| PIS-20 | 89.5 | 20 | 59.5 | 5.5 | 25.0 | 10.0 | 65.0 | 10.8 |
| PIS-21 | 89.5 | 20 | 59.5 | 5.5 | 25.0 | 10.0 | 65.0 | 10.8 |
| PIS-22 | 89.5 | 20 | 70.0 | 8.0 | 18.0 | 4.0 | 78.0 | 8.8 |
| PIS-23 | 89.5 | 20 | 82.0 | 9.5 | 8.5 | 0.0 | 91.5 | 8.6 |

### Examples 1 to 30 and Comparative examples 1 and 8

Additives were added to the polyimide copolymer solutions prepared in Production examples 1 to 23, followed by stirring to provide varnishes that, including the additives, had a solid content of 50 parts by weight. The varnishes were filtered through a PTFE filter with a pore size of 1 µm. The varnishes were examined to make evaluations for the retention of semiconductor elements, adhesive residue, and heat resistance. The proportions of the components of the varnishes and results of the various evaluations are summarized in Tables 2 to 4.

### [Table 2]

**[Table 2]**

| | polyimide copolymer solution (solution with solid content 50 wt%) | epoxy resin | crosslinking agent (C) | other additive | solvent |
|---|---|---|---|---|---|
| | top: type | top: type | top: type | top: type | top: type |
| | bottom: content | bottom: content | bottom: content | bottom: content | bottom: content |
| Example 1 | PIS-1 32.05g | JER871 8.81g | - | 2E4MZ 0.16g | CHN 8.97g |
| Example 2 | PIS-2 32.05g | JER871 8.81g | - | 2E4MZ 0.16g | CHN 8.97g |
| Example 3 | PIS-3 32.05g | JER871 8.81g | - | 2E4MZ 0.16g | CHN 8.97g |
| Example 4 | PIS-4 32.05g | JER871 8.81g | - | 2E4MZ 0.16g | CHN 8.97g |
| Example 5 | PIS-5 32.05g | JER871 8.81g | - | 2E4MZ 0.16g | CHN 8.97g |
| Example 6 | PIS-6 32.05g | JER871 8.81g | - | 2E4MZ 0.16g | CHN 8.97g |
| Example 7 | PIS-3 48.07g | JER871 0.72g | - | 2E4MZ 0.24g | CHN 0.96g |
| Example 8 | PIS-3 46.30g | JER871 1.62g | - | 2E4MZ 0.23g | CHN 1.85g |
| Example 9 | PIS-3 34.24g | JER871 7.71g | - | 2E4MZ 0.17g | CHN 7.88g |
| Example 10 | PIS-3 39.68g | JER871 4.96g | - | 2E4MZ 0.20g | CHN 5.16g |
| Example 11 | PIS-3 31.85g | JER871 8.76g | 100LM 0.16g | 2E4MZ 0.16g | CHN 9.08g |
| Example 12 | PIS-3 41.22g | JER871 4.12g | 100LM 0.06g | 2E4MZ 0.21g | CHN 4.39g |
| Example 13 | PIS-3 39.07g | JER871 3.91g | 100LM 1.37g | 2E4MZ 0.20g | CHN 5.47g |
| Example 14 | PIS-3 40.00g | JER871 4.00g | 100LM 0.80g | 2E4MZ 0.20g | CHN 5.00g |
| Example 15 | PIS-7 40.98g | JER871 4.10g | 100LM 0.21g | 2E4MZ 0.21g | CHN 4.51g |
| Example 16 | PIS-8 40.98g | JER871 4.10g | 100LM 0.21g | 2E4MZ 0.21g | CHN 4.51g |
| Example 17 | PIS-9 40.98g | JER871 4.10g | 100LM 0.21g | 2E4MZ 0.21g | CHN 4.51g |
| Example 18 | PIS-10 40.98g | JER871 4.10g | 100LM 0.21g | 2E4MZ 0.21g | CHN 4.51g |
| Example 19 | PIS-10 32.05g | JER871 8.81g | - | 2E4MZ 0.16g | CHN 8.97g |
| Example 20 | PIS-10 32.05g | JER871 8.81g | 100LM 0.16g | 2E4MZ 0.16g | CHN 8.97g |

### [Table 3]

**[Table 3]**

| | polyimide copolymer solution (solution with solid content 50 wt%) | epoxy resin | crosslinking agent (C) | other additive | solvent |
|---|---|---|---|---|---|
| | top: type | top: type | top: type | top: type | top: type |
| | bottom: content | bottom: content | bottom: content | bottom: content | bottom: content |
| Example 21 | PIS-10 41.32g | JER871 4.13g | - | 2E4MZ 0.21g | CHN 4.34g |
| Example 22 | PIS-11 40.98g | JER871 4.10g | 100LM 0.21g | 2E4MZ 0.21g | CHN 4.51g |
| Example 23 | PIS-19 32.05g | JER871 8.76g | - | 2E4MZ 0.16g | CHN 9.08g |
| Example 24 | PIS-20 32.05g | JER871 8.76g | - | 2E4MZ 0.16g | CHN 9.08g |
| Example 25 | PIS-18 32.05g | JER871 8.76g | - | 2E4MZ 0.16g | CHN 9.08g |
| Example 26 | PIS-21 32.05g | JER871 8.76g | - | 2E4MZ 0.16g | CHN 9.08g |
| Example 27 | PIS-3 32.05g | JER871 8.76g | 100LM 0.26g | 2E4MZ 0.20g | CHN 8.73g |
| Example 28 | PIS-3 32.05g | JER871 8.76g | 100LM 0.40g | 2E4MZ 0.20g | CHN 8.59g |
| Example 29 | PIS-22 40.00g | JER871 4.00g | 100LM 0.80g | 2E4MZ 0.20g | CHN 5.00g |
| Example 30 | PIS-23 40.98g | JER871 4.10g | 100LM 0.21g | 2E4MZ 0.21g | CHN 4.51g |
| Comparative example 1 | PIS-12 32.05g | JER871 8.76g | - | 2E4MZ 0.16g | CHN 9.08g |
| Comparative example 2 | PIS-13 32.05g | JER871 8.76g | - | 2E4MZ 0.16g | CHN 9.08g |
| Comparative example 3 | PIS-14 32.05g | JER871 8.76g | - | 2E4MZ 0.16g | CHN 9.08g |
| Comparative example 4 | PIS-15 32.05g | JER871 8.76g | - | 2E4MZ 0.16g | CHN 9.08g |
| Comparative example 5 | PIS-16 32.05g | JER871 8.76g | - | 2E4MZ 0.16g | CHN 9.08g |
| Comparative example 6 | PIS-17 32.05g | JER871 8.76g | - | 2E4MZ 0.16g | CHN 9.08g |
| Comparative example 7 | PIS-10 49.02g | - | 100LM 0.25g | 2E4MZ 0.25g | CHN 0.49g |
| Comparative example 8 | PIS-10 40.98g | CG500 4.10g | 100LM 0.21g | 2E4MZ 0.21g | CHN 4.51g |

### [Table 4]

**[Table 4]**

| | evaluation results | | | | | | | |
|---|---|---|---|---|---|---|---|---|
| | evaluation for retention of semiconductor elements | | evaluation for adhesive residue | | heat resistance | | chemical resistance | |
| | number of chips held on pressure sensitive adhesive | | | | | | | |
| | press-bonded at room temperature | press-bonded at 100°C | area containing adhesive residue | rating | 1% weight loss temperature | rating | Proportion of residual film | rating |
| | number | number | % | | °C | | % | |
| Example 1 | 88 | 95 | 0 | A | 325 | B | 95 | B |
| Example 2 | 98 | 97 | 0 | A | 310 | B | 91 | B |
| Example 3 | 95 | 95 | 0 | A | 324 | B | 96 | A |
| Example 4 | 93 | 95 | 0 | A | 300 | B | 93 | B |
| Example 5 | 97 | 97 | 3 | A | 308 | B | 91 | B |
| Example 6 | 97 | 93 | 0 | A | 328 | B | 97 | A |
| Example 7 | 97 | 99 | 12 | B | 410 | A | 91 | B |
| Example 8 | 97 | 99 | 7 | A | 403 | A | 94 | B |
| Example 9 | 96 | 97 | 0 | A | 335 | B | 94 | B |
| Example 10 | 95 | 96 | 0 | A | 360 | A | 95 | B |
| Example 11 | 94 | 95 | 0 | A | 329 | B | 99 | A |
| Example 12 | 97 | 99 | 0 | A | 373 | A | 97 | A |
| Example 13 | 95 | 98 | 0 | A | 360 | A | 99 | A |
| Example 14 | 95 | 98 | 0 | A | 362 | A | 99 | A |
| Example 15 | 90 | 95 | 0 | A | 381 | A | 98 | A |
| Example 16 | 98 | 100 | 0 | A | 365 | A | 97 | A |
| Example 17 | 96 | 99 | 0 | A | 373 | A | 98 | A |
| Example 18 | 98 | 100 | 0 | A | 375 | A | 98 | A |
| Example 19 | 93 | 95 | 0 | A | 330 | B | 95 | B |
| Example 20 | 93 | 96 | 0 | A | 328 | B | 100 | A |
| Example 21 | 99 | 100 | 0 | A | 380 | A | 98 | A |
| Example 22 | 98 | 100 | 0 | A | 340 | B | 99 | A |
| Example 23 | 98 | 100 | 30 | C | 350 | A | 91 | B |
| Example 24 | 83 | 90 | 0 | A | 370 | A | 92 | B |
| Example 25 | 97 | 97 | 20 | C | 362 | A | 91 | B |
| Example 26 | 90 | 94 | 0 | A | 275 | C | 85 | C |
| Example 27 | 97 | 99 | 0 | A | 375 | A | 99 | A |
| Example 28 | 94 | 97 | 0 | A | 363 | A | 99 | A |
| Example 29 | 92 | 94 | 0 | A | 366 | A | 99 | A |
| Example 30 | 99 | 100 | 0 | A | 370 | A | 99 | A |
| Comparative example 1 | 20 | 40 | 0 | A | 301 | B | 99 | A |
| Comparative example 2 | 97 | 100 | 1 | A | 270 | C | 85 | C |
| Comparative example 3 | 100 | 100 | 0 | A | 290 | C | 99 | A |
| Comparative example 4 | 95 | 98 | 0 | A | 275 | C | 96 | A |
| Comparative example 5 | 99 | 100 | 89 | D | 280 | C | 60 | D |
| Comparative example 6 | 15 | 35 | 0 | A | 287 | C | 97 | A |
| Comparative example 7 | 95 | 98 | 100 | D | 419 | A | 55 | D |
| Comparative example 8 | 45 | 50 | 0 | A | 390 | A | 99 | A |

## Claims

1. A pressure sensitive adhesive comprising a polyimide copolymer (A) having at least an acid dianhydride residue and a diamine residue and also comprising a dimer acid epoxy resin (B), wherein the diamine residue has a diamine residue (A1) as represented by the formula (1) in which n is a natural number of 1 or more and 15 or less (hereinafter referred to as the diamine residue (A1)), a diamine residue (A2) as represented by the formula (1) in which n is a natural number of 16 or more and 50 or less (hereinafter referred to as the diamine residue (A2)), and a diamine residue (A3) having a phenolic hydroxyl group (hereinafter referred to as the diamine residue (A3)), and
wherein the diamine residue (A1) accounts for 50.0 mol% or more and 95.0 mol% or less, the diamine residue (A2) accounting for 1.0 mol% or more and 40.0 mol% or less, and the diamine residue (A3) accounting for 1.0 mol% or more and 30.0 mol% or less, of all diamine residues, which account for 100.0 mol%, in the polyimide copolymer (A), 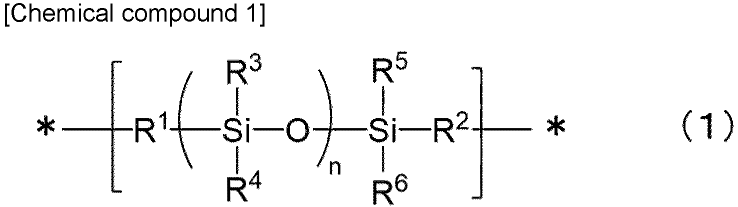
wherein in the formula (1), R¹ and R² may be identical to or different from each other and they each represent an alkylene group containing 1 to 30 carbon atoms or a phenylene group; R³ to R⁶ may be identical to or different from each other and they each represent an alkyl group containing 1 to 30 carbon atoms, a phenyl group, or a phenoxy group; and * denotes a bonding part.

2. A pressure sensitive adhesive as set forth in claim 1, comprising 5 parts by weight or more and 50 parts by weight or less of a dimer acid epoxy resin (B) relative to 100 parts by weight of the polyimide copolymer (A).

3. A pressure sensitive adhesive as set forth in either claim 1 or 2, further comprising a crosslinking agent (C) having either an alkoxy methyl group or a methylol group.

4. A pressure sensitive adhesive as set forth in either claim 1 or 2, wherein the total amount of the diamine residue (A1) and the diamine residue (A2) accounts for 70.0 mol% or more and 98.0 mol% or less of all diamine residues, which account for 100.0 mol%, in the polyimide copolymer (A) and also wherein the molar ratio between the diamine residue (A1) and the diamine residue (A2) is in the range of 5:1 to 30:1.

5. A pressure sensitive adhesive as set forth in claim 3, comprising 0.1 part by weight or more and 5.0 parts by weight or less of the crosslinking agent (C) relative to 100 parts by weight of the polyimide copolymer (A).

6. A substrate coated with a pressure sensitive adhesive layer, comprising a support substrate having thereon a pressure sensitive adhesive layer made of a pressure sensitive adhesive as set forth in either claim 1 or 2.

7. A substrate coated with a pressure sensitive adhesive layer as set forth in claim 6, wherein the pressure sensitive adhesive layer present on the support substrate has a thickness of 0.1 µm or more and 10 µm or less.

8. A layered body comprising semiconductor elements held on the pressure sensitive adhesive layer surface of a substrate coated with a pressure sensitive adhesive as set forth in claim 6.

9. A layered body as set forth in claim 8, having a patterned pressure sensitive adhesive layer.

10. A production method for a layered body, comprising:
a step for placing a laser-transmissive substrate laid with semiconductor elements at least containing a laser-transmissive substrate and semiconductor elements stacked in this order and a substrate coated with a pressure sensitive adhesive layer as set forth in claim 6 in such a manner that the surface of the former where the semiconductor elements are exposed and the surface of the latter where the pressure sensitive adhesive layer is exposed face each other, and
a subsequent step for applying laser light to the laser-transmissive substrate by irradiating that surface of the laser-transmissive substrate laid with semiconductor elements which is opposite to the surface where the semiconductor elements are exposed so that the semiconductor elements are transferred to the substrate coated with a pressure sensitive adhesive layer.

11. A production method for a layered body as set forth in claim 10, further comprising a step for removing part of the pressure sensitive adhesive layer.

12. A production method for a semiconductor device using a layered body as set forth in claim 8, comprising:
a step for placing the layered body and the circuit board in such a manner that the surface of the former where the semiconductor elements are exposed faces the latter and establishing an electric connection between the semiconductor elements and the circuit board by thermocompression bonding, and
a subsequent step for removing the substrate part coated with a pressure sensitive adhesive layer from the semiconductor elements.

13. A circuit board coated with a pressure sensitive adhesive layer, comprising a circuit board having thereon a pressure sensitive adhesive layer made of a pressure sensitive adhesive as set forth in either claim 1 or 2.

14. A layered body comprising a circuit board coated with a pressure sensitive adhesive layer as set forth in claim 13 and semiconductor elements held on the surface thereof where the pressure sensitive adhesive layer is exposed.

15. A production method for a semiconductor device using a layered body as set forth in claim 14, comprising:
a step for applying a pressure in the stacking direction to the layered body to break the pressure sensitive adhesive layer in order to bring the circuit board into contact with the semiconductor elements so that an electric connection is established between the circuit board and the semiconductor elements.

16. A production method for a semiconductor device, comprising:
a step for placing a layered body including a substrate, a pressure sensitive adhesive layer, and a plurality of semiconductor elements stacked in this order and a circuit board in such a manner that the surface of the former where the semiconductor elements are exposed faces the latter,
a step for heating and press-bonding the semiconductor elements and the circuit board at a temperature of 80°C or more and less than 300°C to establish an electric connection between them, and
a subsequent step for removing the pressure sensitive adhesive layer and the substrate part present in the layered body from the semiconductor elements.

17. A production method for a semiconductor device, comprising:
a step for applying a pressure in the stacking direction to a layered body including a circuit board, a pressure sensitive adhesive layer, and a plurality of semiconductor elements in this order to break the pressure sensitive adhesive layer in order to bring the circuit board into contact with the semiconductor elements so that an electric connection is established between the circuit board and the semiconductor elements.

18. A production method for a semiconductor device as set forth in either claim 16 or 17, wherein the pressure sensitive adhesive layer contains polyimide.
